# FASCICULE DE BREVET EUROPEEN

(11) **EP 3 027 555 B1**
(45) Date de publication et mention de la délivrance du brevet: **24.05.2023**
(21) Numéro de dépôt: 14759018.6
(22) Date de dépôt: 30.07.2014
(51) Int. Cl.: C01B 32/225, C01B 32/19

(54) **PROCÉDÉ D'EXFOLIATION DU GRAPHITE ASSISTÉ PAR RÉACTION DE DIELS-ALDER**
VERFAHREN ZUR SCHÄLUNG VON GRAPHIT UNTERSTÜTZT DURCH EINE DIELS-ALDER-REAKTION
METHOD FOR EXFOLIATING GRAPHITE ASSISTED BY A DIELS-ALDER REACTION

(30) Priorité: 31.07.2013 FR 1357602
(43) Date de publication de la demande: 08.06.2016
(73) Titulaire: Université de Bordeaux, 33000 Bordeaux (FR); Institut Polytechnique de Bordeaux 1, 33402 Talence Cedex (FR); Centre National de la Recherche Scientifique (C.N.R.S.), 75794 Paris Cedex 16 (FR)
(72) Inventeur: BASSANI, Dario, F-33600 Pessac (FR); VERLHAC, Jean-Baptiste, F-33400 Talence (FR); BARES, Hugo, Florian, F-33600 PESSAC (FR)
(74) Mandataire: Novagraaf Technologies
(86) Numéro de dépôt international: PCT/FR2014/051976
(87) Numéro de publication internationale: WO 2015/015120

(56) Documents cités:
- EP-A1- 2 327 662
- WO-A2-2012/051597
- KR-A- 20120 104 767
- WANG X ET AL: "Transparent, conductive graphene electrodes for dye-sensitized solar cells", NANO LETTERS, AMERICAN CHEMICAL SOCIETY, US, vol. 8, no. 1, 12 novembre 2007 (2007-11-12), pages 323-327, XP002521165, ISSN: 1530-6984, DOI: 10.1021/NL072838R
- SANTANU SARKAR ET AL: "Diels-Alder Chemistry of Graphite and Graphene: Graphene as Diene and Dienophile", JOURNAL OF THE AMERICAN CHEMICAL SOCIETY, vol. 133, no. 10, 16 mars 2011 (2011-03-16), pages 3324-3327, XP055123014, ISSN: 0002-7863, DOI: 10.1021/ja200118b cité dans la demande
- SANTANU SARKAR ET AL: "Chemistry at the Dirac Point: Diels-Alder Reactivity of Graphene", ACCOUNTS OF CHEMICAL RESEARCH, vol. 45, no. 4, 17 avril 2012 (2012-04-17) , pages 673-682, XP055123017, ISSN: 0001-4842, DOI: 10.1021/ar200302g cité dans la demande
- GARRIGUES BERNARD ET AL: "Microwave-assisted carbonyl Diels-Alder and carbonyl-ene reactions supported on graphite", LIEBIGS ANNALEN: ORGANIC AND BIOORGANIC CHEMISTRY, VCH PUBLISHERS, US, no. 5, 1 janvier 1996 (1996-01-01), pages 743-744, XP002491121, ISSN: 0947-3440
- NICOLAS ZYDZIAK ET AL: "Diels-Alder reactions for carbon material synthesis and surface functionalization", POLYMER CHEMISTRY, vol. 4, no. 15, 12 mars 2013 (2013-03-12), page 4072, XP055123011, ISSN: 1759-9954, DOI: 10.1039/c3py00232b
- OLIVIER RIANT ET AL: "Asymmetric Diels-Alder reaction catalyzed by chiral bases", TETRAHEDRON LETTERS, vol. 30, no. 52, 1 janvier 1989 (1989-01-01), pages 7403-7406, XP055169675, ISSN: 0040-4039, DOI: 10.1016/S0040-4039(00)70709-X

## Description

### PRIORITÉ

La présente demande de brevet revendique la priorité de la demande FR1357602 déposée le 31 juillet 2013.

### DESCRIPTION

### Domaine technique

La présente invention se rapporte à un procédé d'exfoliation de graphite dans des matériaux carbonés facilité par réaction de Diels-Alder, et ses applications, notamment pour la fabrication de composants électroniques ou microélectroniques tels que les électrodes transparentes conductrices.

La présente invention se rapporte également aux adduits Diels-Alder susceptibles d'être obtenus par un tel procédé.

Dans la description ci-dessous, les références entre crochets (**[ ]**) renvoient à la liste des références présentée après les exemples.

### État de la technique

Le graphène est un cristal bidimensionnel (monoplan) de carbone dont l'empilement constitue le graphite. Il possède d'excellentes propriétés électroniques et est potentiellement disponible en grande quantité par exfoliation du graphite.

Des procédés de fabrication du graphène existent, mais ils sont loin d'être optimaux et viables d'un point de vue industriel.

Les procédés existants d'exfoliation mécanique ou assistée par ultrasons du graphite permettent d'obtenir du graphène en dispersion dans un solvant organique. Toutefois, le matériau obtenu présente une densité de défauts qui est proportionnelle au stress mécanique mis en oeuvre, rendant le graphène obtenu impropre aux applications inductrielles visées.

Le graphène peut également être produit par dépôt chimique en phase vapeur (CVD) sur des substrats métalliques capables de catalyser sa formation (eg. Ni, Cu) et transféré sur d'autres substrats par un procédé de délamination. Les avantages sont la possibilité d'obtenir des couches de graphène très minces (une ou deux couches) de grande qualité mais le procédé est long et coûteux.

Quelques tentatives de solubilisation ont été rapportées, principalement par fonctionnalisation du graphite (Chakraborty et al., « Functionalization of potassium graphite », Angew. Chem. Int. Ed., 46, 4486-4488 (2007) [ref 1]) ou d'oxyde de graphite. (Niyogi et al., "Solution Properties of Graphite and Graphene", J. Am. Chem. Soc., 128, 7720-7721 (2006) [ref 2] ; McAllister et al., "Single Sheet Functionalized Graphene by Oxidation and Thermal Expansion of Graphite", Chem. Mater., 2007 ; 19 (18), 4396-4404 [ref 3]).

La modification chimique du graphène par oxydation en oxyde de graphène permet d'obtenir un matériau plus facilement solubilisé dans des solvants polaires et aqueux. Cependant, la réduction de l'oxyde de graphène en graphène est difficile et souvent incomplète et ne permet pas d'obtenir des feuillets de graphène sans défauts.

Quelques procédés de réaction Diels-Alder entre du graphite et un diénophile permettent la fonctionnalisation du graphique, dont la structure reste autrement intacte (KR20120104767 [ref 16] ; Santanu Sarkar et al,. « Diels-Alder chemistry of graphite and graphene: graphene as diene and dienophile », Journal of the american chemical society, vol. 133, no, 10, 16 mars 2011, pages 3324-3327 [ref 19]). Cependant, les procédés de réaction Diels-Alder mentionnés n'abordent pas l'exfoliation.

Il en est de même pour une autre publication qui s'intéresse à un procédé de réaction Diels-Alder entre de l'anthrone et du N-méthylmaléimide, et les moyens de catalyser cette réaction (Olivier Riant et al., « Asymmetric Diels-Alder reaction catalyzed by chiral bases », Tetrahedron letters, vol.30 no. 52, 1 janvier 1989, pages 7403-7406 [ref 20]).

D'une manière générale, les procédés d'exfoliation courants nécessitent l'utilisation de solvant lourds (N-méthylpyrrolidine, point d'ébullition 202°C), fortement halogénés (1,2-dichlorobenzène), ou peu compatibles avec des applications en industrie électronique (liquides ioniques). Par ailleurs, ils nécessitent souvent des doses d'ultrasons élevées conduisant à un fort taux de dégradation du graphène obtenu, lequel est nuisible à son exploitation pour les applications industrielles visées. De plus, ces méthodes présentent l'inconvénient que les plans de graphite obtenus sont fonctionnalisés et/ou dénaturés.

A ce jour le développement industriel du graphène est limité, principalement en raison des difficultés de fabrication et de mise en oeuvre du matériau telles que celles précitées. Il existe un réel besoin d'un procédé palliant les défauts, inconvénients et obstacles précités de l'art antérieur, en particulier d'un procédé permettant d'obtenir des feuillets de graphène de grande qualité avec peu de défauts dans des solvants réputés jusqu'ici peu propices à la solubilisation du graphène.

### Description de l'invention

La présente invention a précisément pour but de répondre à ce besoin en fournissant un procédé d'exfoliation de graphite caractérisé en ce qu'il comprend une réaction Diels-Alder entre du graphite et un composé de type anthrone répondant à l'une des structures suivantes : «----»

R₂, R₃ représentent indépendamment un atome d'hydrogène, -NR^{A}R^{B}, ou -OR ; où chaque occurrence de R, R^{A} et R^{B} représente indépendamment un atome d'hydrogène, ou un groupe méthyle, éthyle, n-propyle, i-propyle, n-butyle, t-butyle, sec-butyle, n-pentyle, ou n-hexyle ; et R, pour chaque occurrence, peut également représenter un radical polyéthylène glycole de formule : 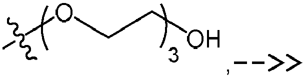 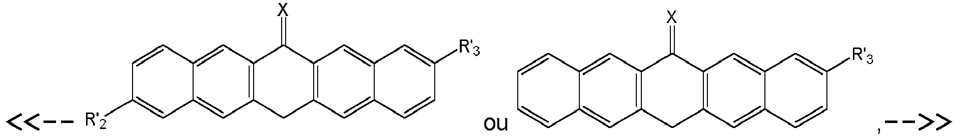 dans laquelle R'₂, R'₃ représentent indépendamment un atome d'hydrogène, -NR^{A}R^{B}, ou -OR ; où chaque occurrence de R, R^{A} et R^{B} représente indépendamment un atome d'hydrogène, ou un groupe méthyle, éthyle, n-propyle, i-propyle, n-butyle, t-butyle, sec-butyle, n-pentyle, ou n-hexyle; et R, pour chaque occurrence, peut également représenter un radical polyéthylène glycol de formule : 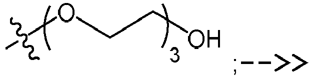 X représente O ou S ; pour conduire à un composé de type pentacènone ayant l'une des structures suivantes : dans laquelle
X représente O ou S ; dans un solvant organique, en présence d'une base, et sous sonication, broyage (« ball-milling » en anglais) et/ou mixage (« high-shear mixing » en anglais), à une température comprise entre 15°C et 65°C ; pour obtenir l'adduit Diels-Alder de graphène correspondant.

Avantageusement, le procédé peut être réalisé avec des composés de type anthrone ou pentacènone correspondants aux figures définies précédemment.

Selon un mode de réalisation, le procédé peut être mis en oeuvre avec des composés tels que définis ci-dessus, sous sonication, et à une température comprise entre 15°C et 65°C.

Avantageusement, le procédé peut être réalisé avec des composés de type thioanthrone ou thiopentacènone correspondants aux figures définies précédemment.

Dans le contexte de la présente invention, on entend par « graphène » un cristal essentiellement bidimensionnel d'atomes de carbone constitué de un à cinq feuillet(s) (monoplan(s)) d'atomes de carbone. Ainsi, dans le présent document, le terme « graphène » couvre la définition stricte (scientifique) du graphène (à savoir un cristal bidimensionnel (monoplan) d'atomes de carbone dont l'empilement constitue le graphite), mais il s'étend également aux multi-feuillets de graphène (2 à 5 feuillets). Ainsi, le terme « graphène » utilisé dans le contexte de la présente invention se réfère à un matériau se présentant sous la forme d'un monofeuillet d'atomes de carbone, de multi-feuillets d'atomes de carbone (2 à 5 feuillets), ou d'un mélange de ceux-ci.

Avantageusement, l'adduit Diels-Alder de graphène précité se présente sous la forme de mono-feuillets, de multi-feuillets de quelques feuillets (2 à 5 feuillets), ou d'un mélange de ceux-ci.

De manière tout à fait surprenante, le procédé de l'invention, grâce à l'utilisation des composés de type anthrone ou pentacènone ou thio-analogues précités, permet donc d'exfolier les feuillets de graphène à partir de graphite, sous forme d'adduit Diels-Alder de graphène (mono- ou multi-feuillets de 2 à 5 feuillets) dans un premier temps, puis en graphène suite à une étape de recuit. En effet, jusqu'à présent, les tentatives de réction Diels-Alder sur des échantillons de graphite n'avaient conduit qu'à la fonctionnalisation dudit graphite, sans exfoliation. (cf. Haddon et al., Accounts of Chemical research, vol. 45(4), 2012, 673-682 [ref 14], Haddon et al. JACS, 133, 2011, 3324-3327 [ref 15], et demande de brevet coréen KR2012-0104767 [ref 16]).

La présente invention constitue la première mise en oeuvre d'une exfoliation du graphite en feuillets de graphène (mono- ou multi-feuillets de 2 à 5 feuillets) via une réaction de Diels-Alder.

Sans vouloir être lié à une théorie particulière, les composés de type anthrone ou thioanthrone selon la présente invention , à la différence d'autres diènes rapportés dans la littérature dans des réactions de Diels-Alder réalisées sur du graphite mais ne conduisant pas à son exfoliation (cf. publications Haddon et al., 2011 et demande de brevet coréen KR2012-0104767 précitées), permettent justement l'exfoliation de feuillets de graphène en raison de la réactivité de ces diènes particuliers : celle-ci est due à leur tautomérisme qui génère *in situ* la forme anthracénol/thioantracénol ou pentacénol/thiopentacènone, respectivement.

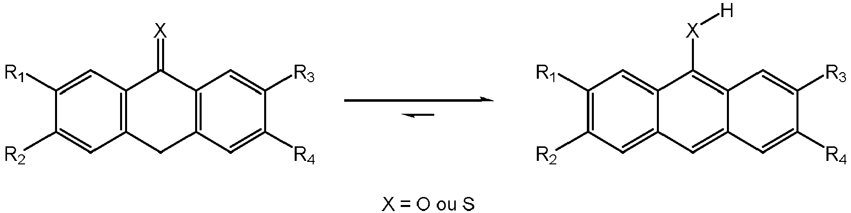

R₁, R₄ représentent indépendamment un atome d'hydrogène.

Cet équilibre tautomérique est accéléré par la présence de base, qui permet aussi de déprotoner l'anthracénol ou le pentacénol, et de former ainsi l'anion anthracénolate ou pentacénolate, respectivement. A titre de comparaison, dans ces conditions, l'anthracénol est un diène 1000 à 10000 fois plus réactif vis-à-vis des réactions de Diels-Alder par rapport à l'anthracène et au 9-méthylanthracène (ainsi qu'à d'autres diènes communs) en raison de la forte densité électronique. Un autre avantage est que les formes anthrone/thioanthrone (et pentacènone/thiopentacènone) sont, elles, apauvries en électrons, ce qui les rend très stables à l'oxydation et à la photo-oxydation. Ceci est très appréciable par rapport au pentacène, qui s'oxyde spontanément à l'air et est photosensible. Par rapport aux composés alcènes, cela inverse la réaction de Diels-Alder car le graphène se comporterait comme un diène.

Par ailleurs, les composés de type (thio)anthrone selon la présente invention permettent, via leur forme tautomère (thio)anthracénol ou (thio)pentacénol, d'obtenir des adduits Diels-Alder de graphène dans des conditions plus douces en raison de leur grande réactivité en présence d'une base. Les adduits présentent un encombrement stérique important (structure triptacène en forme de "papillon") qui est propice à la solubilisation des feuillets de graphène (sous forme d'adduit Diels-Alder). La réaction de rétro-cyclisation, pour donner le graphène initial et l'anthracénol/thioanthacénol ou pentacénol/thiopentacénol, se fait à des températures rélativement basses, ce qui permet d'envisager des applications par dépôt sur des substrats plastiques.

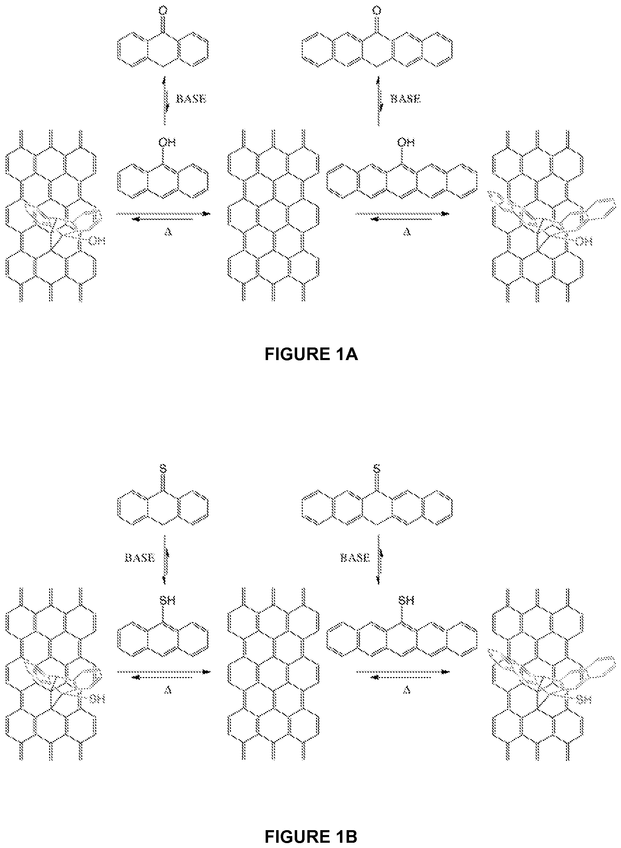

L'exfoliation du graphite en feuillets mono-atomiques (graphène) nécessite beaucoup d'énergie pour contrebalancer les forces d'adhésion qui lient les feuillets entre eux. La présente invention met en oeuvre une réaction réversible entre des composés polyaromatiques et les feuillets de graphène composant le graphite pour induire des distorsions dans les plans mono-atomiques conduisant à leur exfoliation dans des conditions douces. La réaction utilisée est une cycloaddition de Diels-Alder (Figure 1) mettant en jeu un dérivé de l'anthracène ou [n]-acène (n = 3 - 5) (aussi désigné « acène » dans ce qui suit) de formule I ou Il tel que défini ci-dessus possédant des substituants chargés ou neutres capables d'augmenter la réactivité de l'acène vis-à-vis de la réaction de cycloaddition. Le procédé permet d'obtenir du graphène exfolié dans divers solvants. En fonction de la réactivité de l'acène et du solvant utilisé, il peut être nécessaire d'assister le processus d'exfoliation par une légère activation thermique, en plus des ultrasons. Dans le cas de substituants chargés tels que les groupes ammoniums quaternaires (par exemple, -N⁺R^{A}R^{B}R^{C}), les groupes carboxylates (par exemple, -CO₂⁻Na⁺) ou les groupes sulfonates (par exemple, -SO₃⁻Na⁺), les feuillets de graphène ainsi obtenus (1 à 5 feuillets) peuvent également être chargés et peuvent être neutralisés par un agent de protonation ou de déprotonation, ou par une réaction chimique permettant ainsi la post-fonctionalisation du graphène exfolié.

Les suspensions de graphène exfolié obtenues peuvent être très stables et directement utilisées pour diverses applications nécessitant du graphène exfolié. Par exemple, des électrodes conductrices transparentes peuvent être fabriquées en déposant une couche mince d'adduit Diels-Alder de graphène exfolié sur un support transparent. Une étape de recuit sous vide dont la température et la durée dépendent de la nature chimique de l'acène utilisé permet d'éliminer l'acène par sublimation.

Sans vouloir être lié à une théorie particulière, il est proposé que le mécanisme réactionnel met en jeu la formation *in situ* d'un acène très réactif en équilibre avec la forme énone (anthrone pour le 9-anthracénol et le 6,6-dihydroxypentacèn-13-one pour le 6-pentacénol (Figure 1A) ; thioanthrone pour le 9-thioanthracénol et le 6,6-dihydroxythiopentacèn-13-one pour le 6-thiopentacénol (Figure 1B)). Ce dernier réagit rapidement avec les sites diénophiles du graphène pour former un adduit de Diels-Alder dont la structure tridimensionnelle et les centres carbones sp³ déforment la planéité du feuillet de graphène (Figures 1A et 1B). Ceci conduit à son exfoliation et contribue à sa stabilisation en solution. Une base organique quelconque, soluble dans le milieu réactionnel, permet d'accélérer l'échange entre les formes cétonique et énolique de l'acène.

La synthèse d'anthrones et de pentacènones est connue depuis très longtemps. Le lecteur saura adapter les méthodes synthétiques connues pour préparer les composés utilisés dans le cadre de la présente invention, y compris les dérivés portant des substituants alkoxyle, polyéthylèneglycol, amino, ammonium quaternaire, carboxyle, carboxylate, ou sulfonate en positions R₂ à R₃ et R'₂ à R'₃. On peut citer par exemple : Goichi et al., "Improved Synthesis of 1,8-Diiodoanthracene and Its Application to the Synthesis of Multiple Phenylethynyl-Substituted Anthracenes" Synthesis 2005(13): 2116-2118 [ref 12] et Li et al., Synthesis of 1,2,3,4,8,9,10,11-Octasubstituted Pentacenequinone Dérivatives and their Conversion into Substituted Pentacenes, Chemistry - An Asian Journal, 2010, 5, 1620-1626 [ref 13].

Avantageusement, dans le composé de la présente invention R₂, R₃ représentent indépendamment un atome d'hydrogène, -NR^{A}R^{B}, ou -OR ; où chaque occurrence de R, R^{A} et R^{B} représente indépendamment un atome d'hydrogène, ou un groupe méthyle, éthyle, n-propyle, i-propyle, n-butyle, t-butyle, sec-butyle, n-pentyle, ou n-hexyle; et R, pour chaque occurrence, peut également représenter un radical polyéthylène glycol de formule : 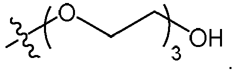 Dans une variante, R₂, R₃ représentent indépendamment un atome d'hydrogène ou -NR^{A}R^{B}, et R^{A} et R^{B} représente indépendamment un atome d'hydrogène, ou un groupe méthyle, ou éthyle. Dans une variante, R₂, R₃ représentent indépendamment un atome d'hydrogène ou - NR^{A}R^{B}, et R^{A} et R^{B} représentent chacun un atome d'hydrogène, ou un groupe méthyle, ou éthyle. Dans une variante, R₂, R₃ représentent indépendamment un atome d'hydrogène ou -NR^{A}R^{B}, et R^{A} et R^{B} représentent chacun un atome d'hydrogène. Dans une variante, R₂, R₃ représentent chacun un atome d'hydrogène.

Avantageusement, le composé de la présente invention a la formule suivante : 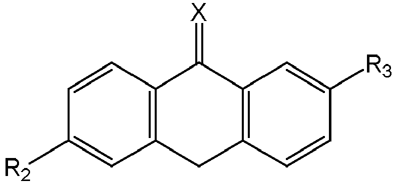 dans laquelle, X, R₂ et R₃ sont tels que définis ci-dessus, dans toutes les variantes décrites ci-dessus.

Avantageusement, le composé de la présente invention a la formule suivante : 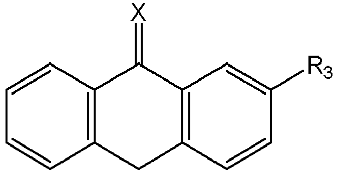 dans laquelle, X et R₃ sont tels que définis ci-dessus, dans toutes les variantes décrites ci-dessus.

Avantageusement, dans le composé de la présente invention, R₂ d'une part, et R₃ d'autre part, forment ensemble un groupe cycloalkyle insaturé en C₆ éventuellement substitué pour conduire à un composé dans lequel R'₂, R'₃ représentent indépendamment un atome d'hydrogène, -NR^{A}R^{B}, ou -OR ; où chaque occurrence de R, R^{A} et R^{B} représente indépendamment un atome d'hydrogène, ou un groupe méthyle, éthyle, n-propyle, i-propyle, n-butyle, t-butyle, sec-butyle, n-pentyle, ou n-hexyle; et R, pour chaque occurrence, peut également représenter un radical polyéthylène glycol de formule : 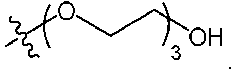 Dans une variante, R'₂, R'₃ représentent indépendamment un atome d'hydrogène ou -NR^{A}R^{B}, et R^{A} et R^{B} représente indépendamment un atome d'hydrogène, ou un groupe méthyle, ou éthyle. Dans une variante, R'₂, R'₃ représentent indépendamment un atome d'hydrogène ou - NR^{A}R^{B}, et R^{A} et R^{B} représentent chacun un atome d'hydrogène, méthyle, ou éthyle. Dans une varianteR'₂, R'₃ représentent indépendamment un atome d'hydrogène ou - NR^{A}R^{B}, et R^{A} et R^{B} représentent chacun un atome d'hydrogène. Dans une variante, R'₂, R'₃ représentent chacun un atome d'hydrogène.

Avantageusement, le composé de la présente invention conduit au composé a la formule suivante : 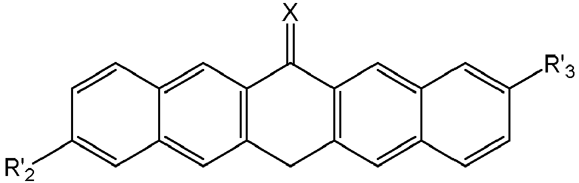 dans laquelle, X, R'₂ et R'₃ sont tels que définis ci-dessus, dans toutes les variantes décrites ci-dessus.

Avantageusement, le composé de la présente invention conduit au composé a la formule suivante : 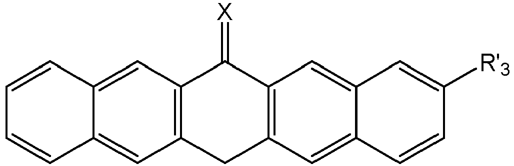 dans laquelle, X et R'₃ sont tels que définis ci-dessus, dans toutes les variantes décrites ci-dessus.

Avantageusement, le composé de la présente invention, répond à l'une des structures suivantes : 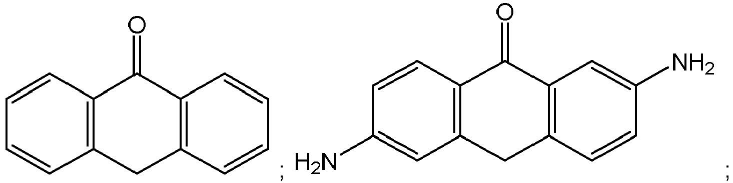 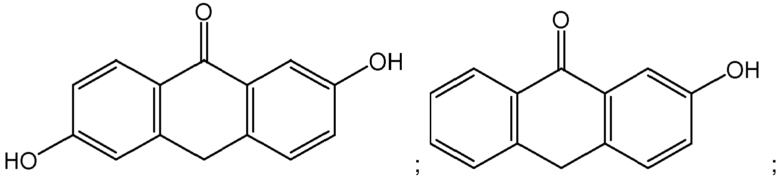 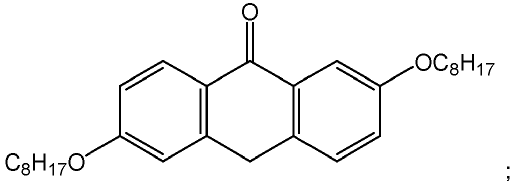 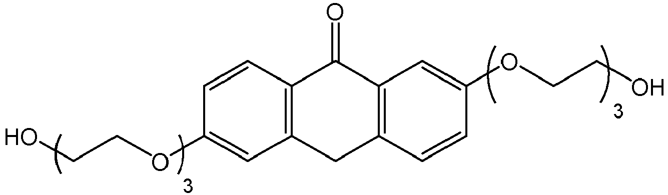 ou

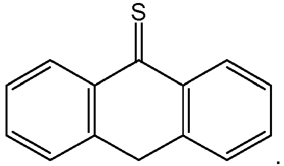

Avantageusement, le solvant organique peut être tout solvant organique connu de l'homme du métier. Il peut s'agir par exemple, d'un hydrocarbure aliphatique ou alicyclique saturé ou insaturé (tel que le n-hexane, n-heptane, n-octane, n-nonane, cyclohexane, méthylcyclohexane), un hydrocarbure aromatique (tel que le benzène, chlorobenzène, 1,2-dichlorobenzène, toluène, o-xylène, m-xylène, p-xylène, éthylbenzène, cumène, mésitylène), un alcool de préférence comprenant au moins 3 atomes de carbone (tel que isopropanol, n-butanol, cyclohexanol), un glycol (tel que éthylène glycol, propylène glycol), un hydrocarbure halogéné (tel que dichlorométhane, chloroforme, trichloroéthylène, 1,1,1-trichloroéthane, tétrachlorure de carbone, perchloroéthylène, 1,1,2-trichlorotrifluoroéthane), une cétone (tel que l'acétone, butanone, 2-pentanone, cyclohexanone, 4-méthyl-2-pentanone, 2-heptanone, 2,6-diméthyl-4-heptanone), un ester (tel que l'acétate d'éthyle, l'acétate de propyle, l'acétate d'isopropyle, l'acétate de butyle, l'actétate d'isobutyle, l'acétate d'amyle, l'acétate de 2-éthylhexyle), un éther (tel que le tétrahydrofurane (THF), éther éthylique, méthyl-t-butyléther, 1,4-dioxane, 1,2-diméthoxyéthane, anisole, 2,5,8-trioxanonane), un éther de glycol (tel que le 1-méthoxy-2-propanol, 2-butoxyéthanol, 2-(2-méthoxyéthoxy)éthanol, acétate de 1-méthoxy-2-propyle, (2-méthoxy-méthyléthoxy)-propanol, éther monométhylique du tripropylène glycol), ou un autre solvant organique tel que l'acétonitrile, la N-méthyl-2-pyrrolidone (NMP), le diméthylformamide (DMF), ou un mélange de deux ou plus de ceux-ci. Avantageusement, on préférera des solvants organiques différents du méthanol ou de l'éthanol. Avantageusement, on pourra utiliser un solvant aromatique, tel que benzène, chlorobenzène, o-dichlorobenzène, etc. Par exemple, le solvant organique peut être le THF, l'acétonitrile, la N-méthyl-2-pyrrolidone (NMP), le diméthylformamide (DMF), le 2-propanol, le toluène, le benzène, le chlorobenzène, le 1,2-dichlorobenzène.

Avantageusement, le solvant pourra être choisi de telle sorte qu'il puisse stabiliser et solubiliser les films de graphène ou d'adduit Diels-Alder de graphène obtenus. Pour ce faire, il pourra être choisi parmi des solvants aprotiques polaires ou aromatiques pas trop polaires.

Avantageusement, la base utilisée peut être toute base connue de l'homme du métier soluble dans le milieu réactionnel. Par exemple, il peut s'agir d'une di- ou trialkylamine, telle que la diéthylamine, diméthylamine, aza-éthercourone, diisopropylamine, diisopropyléthylamine, triéthylamine, triméthylamine, tripropylamine, et tributylamine, N-méthylcyclohexylamine, N-éthylcyclohexylamine, N-méthylcyclopentylamine, N-éthylcyclopentylamine. Il peut également s'agir d'une base azotée aromatique telle que la pyridine, la 2-méthylpyridine, la 3-méthylpyridine, la 4-méthylpyridine, ou la pyrimidine.

Avantageusement, le procédé est conduit sous au moins une des techniques suivantes : sonication, broyage (« ball-milling » en anglais) et mixage (« high-shear mixing » en anglais). Ces techniques, mises en oeuvre seules ou en combinaison, permettent d'accélérer le processus d'exfoliation.

Avantageusement, le procédé est mis en oeuvre sous sonication uniquement. Plus avantageusement, la sonication est suppléée par un broyage et/ou un mixage. Sonication et broyage, ou sonication et mixage peuvent être simultanés ou séquentiels, de préférence séquentiels.

Avantageusement, la sonication est une sonication douce, c'est-à-dire une sonication qui, à elle-seule, ne permet pas l'exfoliation du graphite.

Avantageusement, la sonication est réalisée à l'aide d'un bain à ultrasons opérant à une fréquence adéquate pour réaliser une sonication douce telle que définie ci-dessus. Les appareils prévus à cet effet sont bien connus de l'homme du métier. Par exemple, des sonicateurs opérant à 30 ou 37 kHz peuvent être utilisés. Avantageusement, la puissance et le temps de sonication pourront être ajustés pour permettre une sonication douce, telle que définie ci-dessus, tout en préservant l'intégralité des plans de graphène modifiés par réaction de Diels-Alder selon le procédé de l'invention. Par exemple, la puissance de sonication pourra être de l'ordre de 40 à 150W consommés; et le temps de sonication pourra varier entre 10 minutes et 5 heures.

Avantageusement, le procédé selon l'invention peut être réalisé à température ambiante, c'est-à-dire de 20 à 25°C. Une température légèrement supérieure peut également être avantageuse, par exemple de 25 à 65°C. Typiquement, le procédé selon l'invention peut être réalisé à une température de 20 à 65°C.

L'adduit Diels-Alder de graphène obtenu par le procédé selon l'invention peut être soluble ou insoluble dans le milieu réactionnel, selon la taille des feuillets de graphène exfoliés. Ainsi, selon une variante, le procédé peut comprendre en outre une étape de centrifugation, celle-ci permettant de séparer toute fraction non dissoute de la solution obtenue à l'issue du procédé. L'homme du métier saura déterminer les conditions de centrifugation adéquates pour obtenir une solution limpide, c'est-à-dire ne comprenant pas d'agrégats détectables. Par exemple, la centrifugation peut être effectuée entre 1000 et 5000 tours par minute, pendant 0,1 à 24 heures. Avantageusement, l'étape de centrifugation est effectuée à 3000 tours par minute, pendant 30 minutes à 1 heure.

Avantageusement, la présence d'agrégats dans la solution au cours de la centrifugation est vérifiée à l'oeil nu. Ainsi, un échantillon de la solution peut être prélevé à différents intervalles de temps dans l'étape de centrifugation pour déterminer lorsque celle-ci aura permis d'obtenir une solution limpide (c'est-à-dire sans agrégats visibles à l'oeil nu). L'examen à l'oeil nu permet de détecter des agrégats éventuels ayant une taille minimale de l'ordre du dixième de millimètre (100 microns).

Avantageusement, la présence d'agrégats dans la solution au cours de la centrifugation est vérifiée par microscope optique. Ainsi, un échantillon de la solution peut être prélevé à différents intervalles de temps dans l'étape de centrifugation pour déterminer lorsque celle-ci aura permis d'obtenir une solution limpide (c'est-à-dire sans agrégats visibles au microscope optique). L'examen au microscope optique permet de détecter des agrégats éventuels ayant une taille minimale de l'ordre du micron. Dans un mode de réalisation particulier, l'échantillon de la solution peut être analysé au microscope optique avec un grossissement de 20 à 100.

Selon une variante, le procédé peut comprendre en outre une étape de filtration du surnageant obtenu à l'issue de la centrifugation pour isoler l'adduit Diels-Alder (« adduit DA ») de graphène chimiquement modifié obtenu par le procédé, que celui-ci soit soluble ou non dans le milieu réactionnel (si soluble ou partiellement soluble, le surnageant est récupéré : si insoluble ou partiellement insoluble, la fraction insoluble est récupérée). Par exemple, après l'étape de filtration, dans le cas où l'adduit DA est insoluble ou partiellement soluble, celui-ci peut être rincé avec le même solvant utilisé lors du procédé. L'adduit ainsi rincé peut être éventuellement séché.

Le broyage (ball-milling) peut être mis en oeuvre par toute technique et instrument connu de la personne du métier. Par exemple, on pourra se référer à Zhao, W., Fang, M., Wu, F., Wu, H., Wang, L. & Chen, G. Préparation of graphene by exfoliation of graphite using wet ball milling. J. Mater. Chem. 20, 5817-5817 (2010) [ref 17].

Le mixage (high-shear mixing) peut être mis en oeuvre par toute technique et instrument connu de la personne du métier. Par exemple, on pourra se référer à Nature materials, 2014, 13, 624-630) [ref 18].

Une fois l'adduit Diels-Alder de graphène obtenu et isolé, les feuillets de graphène exfoliés (sous forme d'adduit Diels-Alder) peuvent être soumis à un recuit pour renverser la réaction Diels-Alder (rétro-réaction de Diels-Alder), et obtenir ainsi du graphène en tant que tel (monofeuillets, multifeuillets de 2 à 5 feuillets ou mélange de ceux-ci). Ainsi, avantageusement, le procédé peut comprendre en outre une étape de recuit sous vide de l'adduit Diels-Alder de graphène pour obtenir du graphène en tant que tel. Cette étape de recuit peut être réalisée par exemple à une température de 150 à 200°C, de préférence 160 à 180°C. Avantageusement, l'étape de recuit peut être réalisée sous vide, par exemple à une pression réduite inférieure ou égale à 1,33322 Pa (≤0,01 mmHg), de préférence entre 1,33322.10⁻³ Pa (10⁻⁵ mmHg) et 1,33322 Pa (≤0,01 mmHg).

Le graphène, exclu de la présente invention, ainsi obtenu peut se présenter sous la forme de mono-feuillets ou de multi-feuillets de quelques feuillets (2 à 5), ou un mélange de ceux-ci.

Avantageusement, l'adduit DA peut être soluble ou partiellement soluble dans le milieu réactionnel et peut être contenu au moins en partie dans le surnageant. L'obtention d'adduit DA de graphène sous forme de solutions présente un grand intérêt pour leurs applications industrielles, en particulier pour leur mise en forme en vue d'une utilisation donnée. De telles solutions sont en effet facilement utilisables pour déposer des plans d'adduit DA de graphène sur un substrat donné, pour former des films d'adduit de graphène, ou pour élaborer, par imprégnation, des composites renfermant du graphène. En effet, une fois l'adduit DA de graphène déposé sur ledit substrat, celui-ci peut-être soumis à un recuit pour obtenir des feuillets de graphène (par retro-réaction de Diels-Alder), comme décrit ci-dessous. Ces solutions ouvrent également la voie à la purification du graphène.

D'une manière générale, le procédé de l'invention peut être mis en oeuvre avec ou sans agitation. Lorsqu'un système d'agitation est utilisé, il peut s'agir d'un système d'agitation mécanique, magnétique ou par sonication. Dans un mode de réalisation particulier, le procédé est effectué sous agitation mécanique. Dans un autre mode de réalisation, le procédé est effectué sous agitation magnétique. Avantageusement, le procédé de l'invention peut être mis en oeuvre sans autre système d'agitation que la sonication.

Avantageusement, lorsque l'adduit DA de graphène est soluble dans le milieu réactionnel, le procédé selon l'invention comprend en outre une étape de dépôt de plans d'adduit DA de graphène sur un substrat donné. De préférence, ce dépôt est effectué sous atmosphère inerte. Une fois le dépôt effectué et le solvant éliminé, le substrat peut être soumis à un recuit sous vide : les plans de graphène sont alors en interaction avec la surface et restent stabilisés sur la surface.

Le dépôt peut se faire par simple dépôt d'une quantité de solution d'adduit DA de graphène sur un substrat, suivi de l'évaporation du solvant utilisé afin d'isoler les plans d'adduit DA de graphène. Par exemple, la solution d'adduit DA de graphène selon l'invention peut être déposée sur un substrat donné, et le solvant évaporé sous atmosphère inerte. Des plans d'adduit DA de graphène déposés sur le substrat peuvent ainsi être obtenus, une fois le solvant polaire aprotique évaporé.

Le dépôt d'adduit DA de graphène peut également être effectué par dépôt par application, par exemple avec un pinceau ou autre instrument permettant le dépôt d'un film de solution d'adduit DA de graphène sur un substrat donné.

Le dépôt d'adduit DA de graphène peut également être effectué par dépôt par trempage (« dip-coating »). Par exemple, le substrat peut être trempé dans la solution d'adduit DA de graphène un certain temps afin de permettre l'adsorption des plans d'adduit DA de graphène sur la surface du substrat. Le substrat est ensuite retiré de la solution, de préférence à une vitesse uniforme pour obtenir un revêtement uniforme, et le solvant est évaporé.

Le dépôt d'adduit DA de graphène peut également être mis en oeuvre par dépôt à la tournette (« spin coating »). Par exemple, une goutte de solution d'adduit DA de graphène peut être déposée sur un substrat en rotation, éventuellement à haute température. De préférence, la vitesse de rotation est maintenue constante durant le processus de façon à obtenir un dépôt uniforme, et le solvant est évaporé. Lorsque le dépôt à la tournette est effectué à haute température, ladite température peut être entre 10 et 200 °C. Lorsque la température est de l'ordre de 80-200°C, l'adduit DA de graphène peut subir une rétro-réaction de Diels-Alder pour donner du graphène en tant que tel.

Le dépôt d'adduit DA de graphène peut également être mis en oeuvre par dépôt et séchage d'une goutte de solution (« drop-casting»). Par exemple, une goutte de solution d'adduit DA de graphène peut être déposée sur un substrat. La goutte de solvant est ensuite évaporée, éventuellement à une température élévée en fonction du solvant à évaporer.

De telles méthodes sont connues de l'homme du métier, qui saura adapter les conditions de mise en oeuvre en fonction des paramètres tels que la nature du substrat, les interactions entre le substrat et les plans de graphène, la mouillabilité du substrat par le solvant, et autres paramètres dont l'homme du métier reconnaîtra la pertinence.

Les substrats susceptibles d'être utilisés comprennent de manière non exhaustive les céramiques, les métaux, le verre, la silice, le mica, le graphite et/ou les plastiques. Dans un mode de réalisation, le substrat peut être tout substrat connu, utilisé et/ou adapté pour le dépôt de nanotubes de carbone ou de plans de graphène. Par exemple, le substrat peut être du HOPG (highly oriented pyrolytic graphite), Si/SiO₂ ou mica.

La présente invention fournit également un adduit Diels-Alder de feuillets de graphène susceptible d'être obtenu par un procédé selon l'invention.

Du graphène, exclu de la présente invention, est susceptible d'être obtenu par le procédé selon l'invention. Le graphène peut se présenter sous forme de plans de graphène isolés et/ou de rubans de graphène. Par exemple, les plans de graphène peuvent être déposés sur un substrat ou mélangés à un autre matériau.

Le graphène, exclu de la présente invention, susceptible d'être obtenu par le procédé selon l'invention peut être utilisé pour la préparation de matériaux composites.

Avantageusement, le matériau composite peut être obtenu par un procédé comprenant une étape de mélange de graphène susceptible d'être obtenu par un procédé selon l'invention et d'une solution de polymère ou d'un mélange de polymères. Pour la mise en oeuvre, le lecteur pourra se référer par exemple au contenu du document WO 2009/056696 et en adapter l'enseignement.

Avantageusement, le graphène, exclu de la présente invention, susceptible d'être obtenu par le procédé de l'invention peut être utilisé pour la fabrication de composants électroniques ou microélectroniques, tels que les condensateurs ou les transistors.

Encore avantageusement, le graphène, exclu de la présente invention, susceptible d'être obtenu par le procédé de l'invention peut être utilisé pour la fabrication d'électrodes conductrices transparentes, de dispositifs électroluminescents OLED ou de cellules photovoltaïques organiques ou hybrides.

Les inventeurs de la présente invention sont les tous premiers à avoir réalisé un procédé de préparation du graphène par exfoliation du graphite assistée par une réaction de Diels-Alder.

Avantageusement, le graphite peut provenir de toute source de matériau carboné susceptible de contenir du graphite. Bien entendu, le procédé selon l'invention peut être réalisé sur du graphite, par exemple du HOPG (highly oriented pyrolytic graphite), ou du graphite amorphe ou cristallin. Le procédé selon l'invention peut également être réalisé sur du graphite présent dans du noir de charbon. Le noir de charbon est utilisé en grande échelle pour la fabrication de piles et de composants conducteurs. Son utilisation à partir de suspensions dans un liquide présente un intérêt industriel pour faciliter la mise en forme de produits, mais nécessite la dispersion du noir de charbon. Le procédé selon l'invention permet justement la stabilisation de suspensions de noir de charbon à haute teneur en graphite.

Cette invention ouvre ainsi deux voies prometteuses pour le domaine du graphène : la disponibilité de plans de graphène ouvre de vastes perspectives pour la préparation de matériaux composites par mélange avec des polymères ou polymérisation avec le graphène. Les dépôts de plans de graphène sur un substrat, facilement faisables à grande échelle grâce à la présente invention, peuvent désormais devenir une routine et permettre une véritable exploration de l'électronique du graphène moyennant des dépôts contrôlés par auto-assemblage, dépôt sous champ, etc.

Comme l'homme du métier peut le constater à la lecture de la présente description, un des principaux avantages de la présente invention est la simplicité de mise en oeuvre du procédé, ainsi que son habilité à fournir des quantités illimitées de plans de graphène. Le procédé selon l'invention permet également d'obtenir des feuillets de graphène de grande qualité avec peu de défauts dans des solvants réputés jusqu'ici peu propices à la solubilisation du graphène (tétrahydrofurane, acétonitrile). Ceci ouvre de nombreuses perspectives, notamment :
1) En électronique : notamment pour la fabrication de substrats conducteurs transparents pouvant remplacer les électrodes transparents à base d'oxydes semiconducteurs dans les dispositifs électroluminescents et photovoltaïques. Le procédé selon l'invention pourrait être utilisé pour la fabrication d'une nouvelle génération de transistors ultra rapides, de dimension nanométrique. En effet il présente des propriétés inusuelles résultantes de sa structure électronique fortement délocalisée. Dans le graphène, la séparation entre la bande de conduction et la bande de valence peut être ajustée en variant la densité des défauts, ce qui permet de passer d'un matériau parfaitement conducteur à un matériau semi-conducteur.

En fonction de la nature électronique du graphène, il peut trouver application dans la fabrication d'électrodes conductrices transparentes en remplacement de l'ITO pour la fabrication d'écrans plats, de dispositifs électroluminescents OLED, ou de cellules photovoltaïques organiques ou hybrides. Sous forme semi-conductrice, il peut être utilisé comme couche active dans les transistors organiques (OFET) et capteurs.

De plus la mobilité électronique théorique est de 200 000 cm².V⁻¹.s⁻¹ ce qui fait que ce matériau est particulièrement attractif pour l'électronique haute fréquence et térahertz (Le graphène étant un cristal bidimensionnel, les électrons se déplacent sur le graphène à une vitesse de 1 000 km.s⁻¹, soit presque 150 fois la vitesse des électrons dans le silicium (7 km.s⁻¹)).

2) Physique fondamentale : L'une des propriétés les plus spectaculaires du graphène est de posséder des électrons au niveau de Fermi dont la masse apparente est nulle, et constitue ainsi le seul système physique faisant apparaitre des fermions de masse nulle, ce qui est d'un très grand intérêt pour la recherche. L'un des effets les plus frappants est l'apparition sous un champ magnétique d'un effet Hall quantique à température ambiante.

3) D'autres applications (lubrification, polymères composites, films barrière protection oxygène) résultantes des propriétés mécaniques du graphène sont également possibles. En effet, notamment dans le domaine des matériaux, des mesures ont établi que le graphène possède une résistance à la rupture 200 fois supérieure à celle de l'acier et qu'il est 6 fois plus léger. Un ajout de graphène dans un polymère permet d'augmenter la dureté et la stabilité thermique du polymère.

4) Des applications pour la fabrication de matériaux hybrides à base de graphène contenant des sites métalliques (complexes de métaux de transition, nanoparticules métalliques) sont également envisageables en mettant en oeuvre le procédé selon l'invention avec des dérivés thioanthrones et thiopentacènones. En effet, la fonction thiol libérée par réaction de Diels-Alder avec le graphite permet de complexer le site métallique. Ces matériaux sont intéressants pour des applications en catalyse, en imagerie, et en analyse.

Le procédé proposé est particulièrement intéressant car il met en oeuvre une modification chimique du graphène qui est parfaitement réversible et permet de préserver la structure électronique du graphène après mise en oeuvre. Ce procédé permet d'utiliser des conditions d'exfoliation du graphite par ultrasons plus douces (en termes de temps et de puissance) et d'obtenir des dispersions de graphène dans des solvants réputés difficiles (THF, acétonitrile) mais intéressants pour la formulation d'encres et pour le dépôt sur substrats flexibles ou de grandes dimensions. Les composés utilisés sont soit commerciaux, soit accessibles en quelques étapes à partir de composés commerciaux.

Pour des exemples de mise en oeuvre des utilisations précitées, le lecteur pourra se référer aux références 4 à 11 citées dans la Liste des Références.

D'autres avantages pourront encore apparaître à l'homme du métier à la lecture des exemples ci-dessous, illustrés par les figures annexées, donnés à titre illustratif.

### Brève description des figures

- La Figure 1 représente un schéma de l'équilibre céto-énolique de l'anthrone (gauche) et de la 6,6-dihydroxypentacèn-13-one (droite) donnant respectivement l'anthracénol et le pentacénol, et réaction de ces derniers avec les sites diénophiles des plans de graphène.

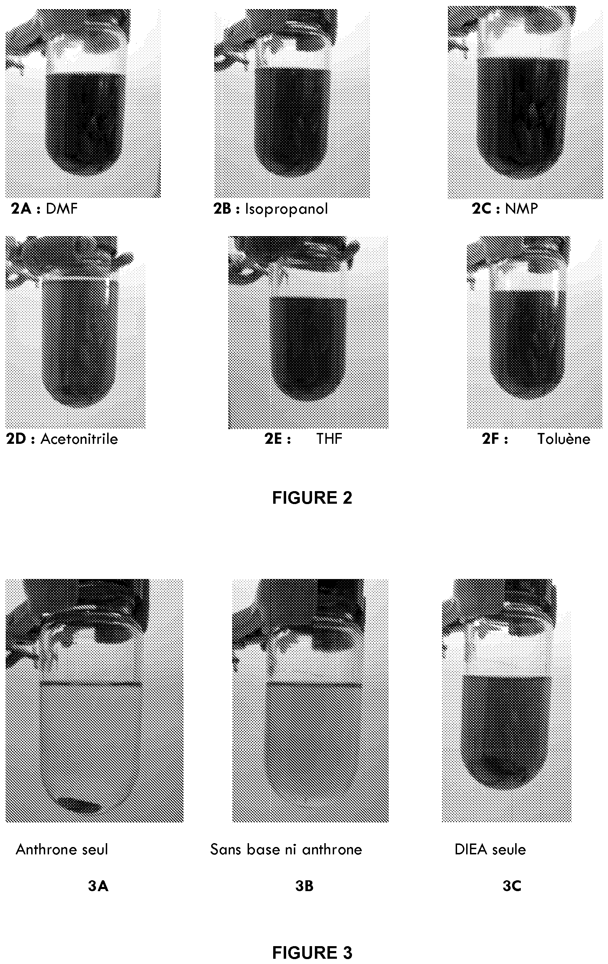

- La Figure 2 illustre des photos des échantillons obtenus dans les exemples 1 à 3 après centrifugation.
- La Figure 3 représente des expériences complémentaires sans base (3A), sans anthrone (3C), et, sans anthrone ni base (3B) dans le THF : 4h de sonication et 30 min de centrifugation à 3000 rpm.

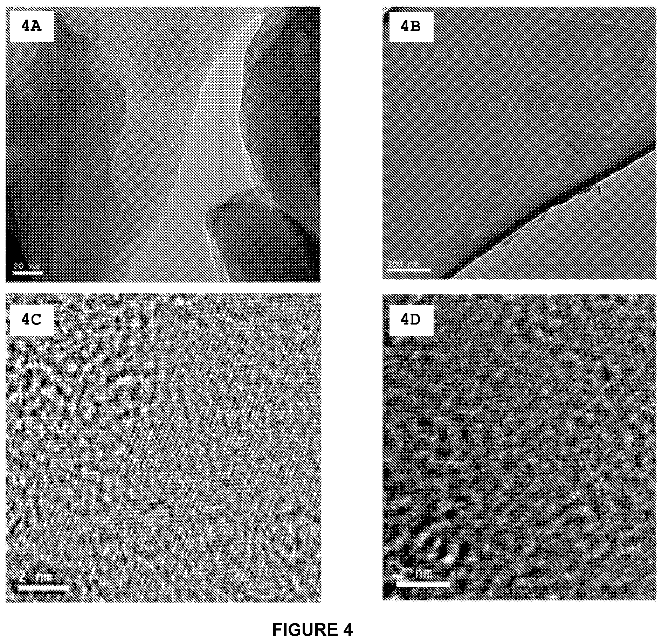

- La Figure 4 représente des images TEM (Microscopie Electronique en Transmission) de feuillets d'adduit Diels-Alder de graphène obtenus par l'utilisation d'anthrone (4A et 4C) ou de pentacènone (4B et 4D) tel qu'indiqué dans les exemples 1 et 2, respectivement.

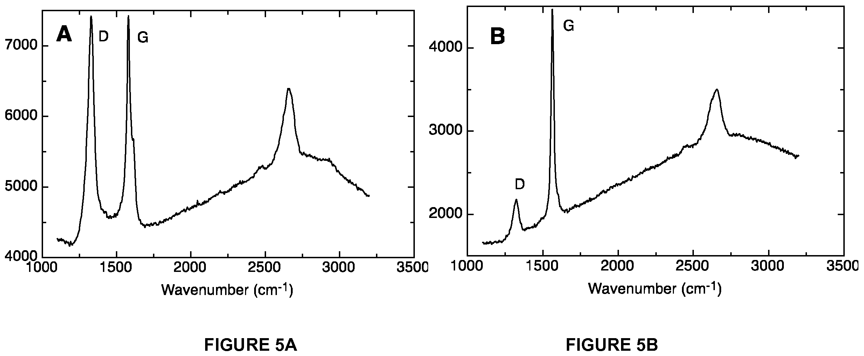

- Figure 5 : **A**: spectre Raman d'un échantillon de graphite exfolié selon le procédé de l'invention en utilisant de l'anthrone de formule I (R₁-R₄ = H, solvant = THF, base = diisopropyléthylamine) déposé sur une lame de verre et séché à l'air. **B**: spectre Raman d'un échantillon de graphite exfolié selon le procédé de l'invention en utilisant de l'anthrone de formule I (R1-R4 = H, solvant = THF, base = diisopropyléthylamine) déposé sur une lame de verre et séché à l'air après recuit à 200°C sous vide 60 min. L'intensité de la bande D est proportionnelle à la présence de défauts (atomes de C sp3). On peut donc utiliser le ratio I_{D}/I_{G} pour en déduire le taux de défauts (bordures des feuillets, adduits de DA, ou autre). On voit que I_{D}/I_{G} est important (ca. 1) après exfoliation, et qu'il diminue sensiblement (I_{D}/I_{G} = 0.14) si on chauffe. Les défauts diminuent car la réaction de Diels-Alder est réversible et on reforme le graphène. On obtient ainsi un film de feuillets de graphène avec peu de défauts. Les défauts résiduels peuvent être dus aux effets de bords, ou à la présence de défauts mineurs produits lors de la sonication.
- Figure 6 : **A** Tableau compilant les concentrations de graphène obtenues dans le THF à l'Exemple 3. **B** Photos correspondantes des divers échantillons obtenus.
- Figure 7 : Solutions obtenues à l'Exemple 6 (X=S) après filtration et redispersion dans le THF (à gauche, C = 0,0335 mg/ml) et dans le toluène (à droite, C = 0,0495 mg/ml).

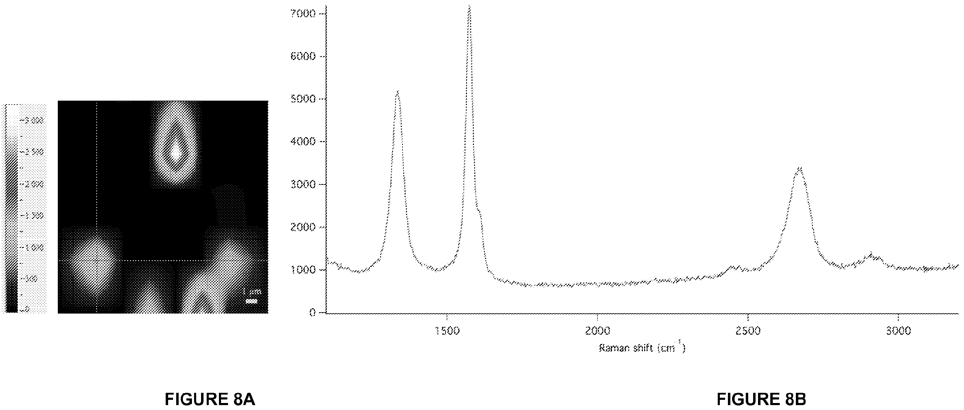

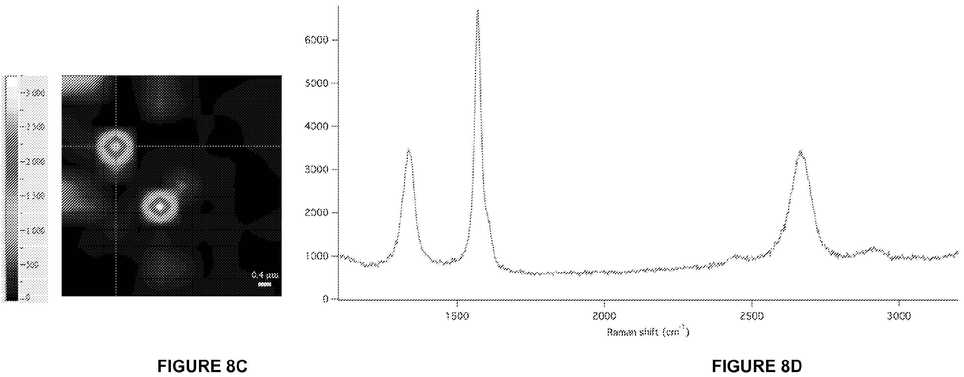

- Figure 8 : **A** Cartographie réalisée sur des zones d'environ 10 µm², par pas de 2 µm d'une solution de graphène dans le THF obtenue à l'Exemple 9. **B** Spectre DIC (Differential interférence Contrast)/Raman à λ = 568 nm correspondant à l'échantillon de la Figure 8A. **C** Cartographie réalisée sur des zones d'environ 10 µm², par pas de 6 µm d'une solution de graphène dans le THF obtenue à l'Exemple 9. **D** Spectre DIC (Differential interférence Contrast)/Raman à λ = 568 nm correspondant à l'échantillon de la Figure 8B. Dans les Figures 8A et 8C, la différence de couleur représente les différences d'intensité de la bande G, à 1578 cm⁻¹. La longueur d'onde utilisée est 568 nm.
- Figure 9 : Schéma du système utilisé à l'Exemple 10 pour la mesure de la conductivité des couches de graphène par la méthode des 4 pointes (four-probe points method).
- Figure 10 : Photos des différentes solutions de noir de charbon obtenues à l'Exemple 12 après sonication et décantation pendant 20 jours (3 mois pour le DMSO).

### EXEMPLES

### Exemple 1 : Préparation de composés de formule (I)

### 1) 2,6-Diaminoanthracen-9(10H)-one

La 2,6-diaminoanthracen-9(10*H*)-one est synthétisée à partir de 2,6-diaminoanthracene-9,10-dione commerciale en utilisant une méthode de réduction par l'Étain (Sn) 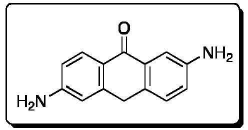 (Tetrahedron Letters, 2011, 52, 5083). Le rendement est de 80 % après purification.

**¹H-NMR** (300 MHz, DMSO) δ (ppm) = 7.86 (d, *J* = 8.4 Hz, 1H), 7.31 (d, *J* = 2.5 Hz, 1H), 7.15 (d, *J* = 8.3 Hz, 1H), 6.83 (dd, *J* = 8.5 Hz 2.6 Hz, 1H), 6.61 (dd, *J* = 8.5 Hz 2.2 Hz, 1H), 6.52 (d, *J* = 2.1 Hz, 1H), 6.04 (s, 2H), 5.19 (s, 2H), 4.04 (s, 2H).

**¹³C-NMR** (75 MHz, DMSO) δ (ppm) = 181.684, 152.93, 147.195, 143.639, 132.454, 128.898, 127.694, 120.658, 119.052, 113.26, 110.545, 109.761, 30.974

**HRMS** (+TOF MS) : Trouvée : [M+Na] 247.0841 Calculée : 247.0841

### 2) 2,6-dihydroxyanthracen-9(10H)-one

La 2,6-dihydroxyanthracen-9(10*H*)-one est synthétisée à partir de 2,6-dihydroxyanthracene-9,10-dione commerciale en utilisant une méthode de réduction par le chlorure d'étain 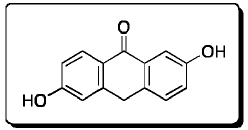 en milieu acide (Tetrahedron Letters, 2003, 44, 945-948). Le rendement est de 65 % après purification.

**¹H-NMR** (300 MHz, DMSO) δ (ppm) = 8.35 (d, *J* = 8.1 Hz, 1H), 8.30 (d, *J* = 8.6 Hz, 1H), 7.58 (td, *J* = 7.4 Hz 1.9 Hz, 1H), 7.46 (m, 2H), 6.94 (dd, *J* = 8.7 Hz 2.4 Hz, 1H), 6.90 (d, *J* = 2.1 Hz, 1H), 4.315 (s, 2H).

**¹³C-NMR** (75 MHz, DMSO) δ (ppm) = 182.086 , 161.629 , 156.104 , 143.983 , 132.493 , 131.307 , 129.969 , 129.319 , 123.641 , 120.926 , 115.382 , 113.891 , 111.271 , 31.031.

**HRMS** (CI-DEP) : Trouvée : [M-H]⁺ = 227.07065 Calculée : 227.07082.

### 3) 2,6-bis(octyloxy)anthracen-9(10H)-one

La 2,6-bis(octyloxy)anthracen-9(10*H*)-one est synthétisée à partir de la 2,6-bis(octyloxy)anthracene- 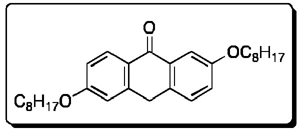 9,10-dione par l'utilisation de zinc activé, en milieu basique (Helvetica Chimica Acta 2006, 89, 333). Le rendement est de 99 %.

**¹H-NMR** (300 MHz, CDCl₃) δ (ppm) = 8.34 (d, *J* = 8.8 Hz, 1H), 7.8 (d, *J* = 2.8 Hz, 1H), 7.33 (d, *J* = 8.5 Hz, 1H), 7.15 (dd, *J* = 8.5 Hz 2.8 Hz, 1H), 6.98 (dd, *J* = 8.8 Hz 2.5 Hz, 1H), 6.88 (d, *J* = 2.6 Hz, 1H), 4.23 (s, 2H), 4.06 (q, *J* = 6.1 Hz, 4H), 1.82 (m, 4H), 1.48 (m, 4H), 1.30 (m, 16H), 0.89 (m, 6H).

**¹³C-NMR** (75 MHz, CDCl₃) δ (ppm) = 183.382, 162.887, 158.318, 133.177, 132.737, 130.061, 129.564, 125.510, 121.840, 114.689, 112.548, 109.776, 68.480, 32.155, 31.964, 29.479, 29.364, 29.307, 26.152, 22.802, 14.241.

**HRMS** (FD+) : Trouvée : [M+] 450.31151 Calculée : 450.31339

### 4) 2-hydroxyanthracen-9(10H)-one

La 2-hydroxyanthracen-9(10*H*)-one est synthétisée à partir de 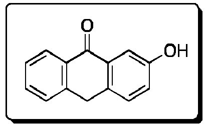 la 2-hydroxyanthracene-9,10-dione par la méthode de réduction par le chlorure d'étain en milieu acide (Tetrahedron Letters, 2003, 44, 945-948).

**¹H-NMR** (300 MHz, DMSO) δ (ppm) = 8.35 (d, J = 8.1 Hz, 1H), 8.30 (d, J = 8.6 Hz, 1H), 7.58 (td, J = 7.4 Hz 1.9 Hz, 1H), 7.46 (m, 2H), 6.94 (dd, J = 8.7 Hz 2.4 Hz, 1H), 6.90 (d, J = 2.1 Hz, 1H), 4.315 (s, 2H).

**¹³C-NMR** (150 MHz, DMSO) δ (ppm) = 181.976, 161.816, 143.582, 140.637, 132.340, 131.494, 129.343, 128.709, 123.642, 115.447, 113.850, 31.675.

**HRMS** (FD+) : Trouvée : [M+] 210.06762 Calculée : 210.06808

### 5) 2,6-bis(2-(2-(2-hydroxyéthoxy)éthoxy)éthoxy)anthracen-9(10H)-one

La 2,6-bis(2-(2-(2-hydroxyéthoxy)éthoxy)ét hoxy)anthracen-9(10*H*)-one est synthétisée par 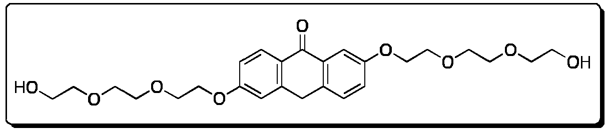 réduction de la 2,6-bis(2-(2-(2-hydroxyéthoxy)éthoxy)éthoxy)anthracène-9,10-dione (Eur. J. Org. Chem. 2000, 591), avec le borohydrure de sodium, suivie d'une déshydratation en milieu acide. À la fin de la réaction, un mélange d'anthrone, d'anthraquinone et d'anthracène est obtenu. La séparation n'a pas été possible et le produit est utilisé directement.

**LRMS** (+TOF MS) : [M+Na] = 513.2

### 6) Thioanthrone :

1) À partir du 9-bromoanthracène dans l'éther diéthylique, le lithien correspondant est formé par addition de n-BuLi à 0 °C puis un ajout de Soufre minéral permet de former le 9-anthracènethiol (Asian Journal of Organic Chemistry, 2012, 1, 274).
2) À partir de l'anthrone, par réaction avec le réactif de Lawesson dans le toluène à 80 °C. Après traitement, le composé récupéré est le 9-anthracènethiol (en équilibre "céto-énolique" avec le composé thioanthrone).

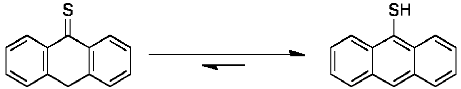

D'après la RMN du produit cristallisé, les deux espèces sont présentes en solution. Le produit majoritaire en solution est l'anthracenethiol :
**¹H-NMR** (400 MHz, CDCl₃) δ (ppm) = 8.63 (dd, J = 8.9 Hz ; 1.4 Hz, 2H), 8.38 (s, 1H), 8.00 (dd, J = 8.4 Hz ; 1.4 Hz, 2H), 7.59 (ddd, J = 8.9 Hz ; 6.6 Hz ; 1.4 Hz, 2H), 7.50 (ddd, J = 8.4 Hz ; 6.6 Hz ; 1.4 Hz, 2H), 3.68 (s, 1H).
**¹³C-NMR** (100 MHz, CDCl₃) δ (ppm) = 129.122, 127.132, 126.484, 126.255, 125.449.
**LRMS :** [M+] = 210.0
**HRMS** (CI-DEP) : Trouvée : [M-H]+ = 211.05785 Calculée : 211. 05815.

### Exemple 2 : Exfoliation de graphite grâce à une réaction Diels-Alder utilisant de l'anthrone

Dans un tube pour centrifugeuse de 100 ml sont introduits l'anthrone de formule I:

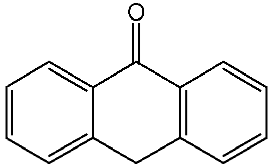

(200 mg, 1.03 mmol), du graphite en poudre (100 mg), la *N*,*N*-diisopropyléthylamine (30 mg, 0.23 mmol) et du THF (50 ml). Le mélange est mis à soniquer dans un bain à ultrasons (30 kHz,150W) pendant 4 heures puis centrifugé pendant 30 minutes à une vitesse de 3000 tours par minute afin de séparer le graphite non exfolié. Le surnageant est alors prélevé à la pipette puis filtré sur un filtre nylon (0,22 µm de diamètre des pores), préalablement séché et pesé. L'ensemble (filtre et filtrat) est alors séché puis pesé. Une masse d'adduit Diels-Alder de graphène de 1.0 mg est ainsi obtenue, soit une concentration de 0.02 mg.ml⁻¹ d'adduit Diels-Alder de graphène en suspension dans le surnageant.

### Exemple 3 : Exfoliation de graphite grâce à une réaction Diels-Alder utilisant des dérivés de l'anthrone

Méthode : 100 mg de graphite, 50 mg de produit dérivé d'anthrone, 25 mg de DIPEA (diisopropyléthylamine) sont mis en solution dans 50 ml de THF (C_{graphite} = 2 mg/ml) et soniqués 4 h à 60-65 °C (180 W, 37 kHz) dans un bain à ultrasons. Le mélange est alors centrifugé 30 minutes à 3000 rpm puis laissé décanter 24 h. Le surnageant est ensuite prélevé puis filtré sur des filtres nylon (taille des pores 0,22 µm). Le solide obtenu est ainsi redispersé dans 10 ml de THF.

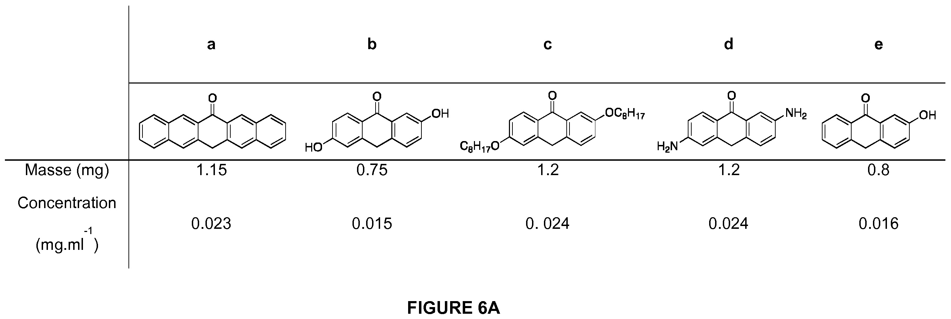

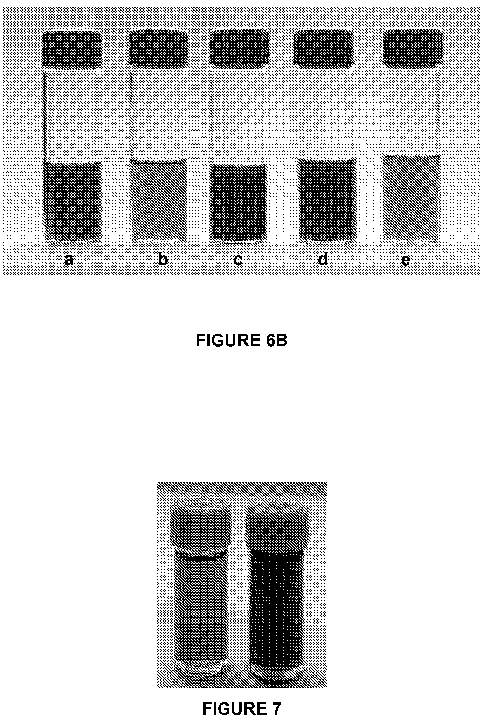

Les résultats sont répertoriés dans les Figures 6A et 6B.

### Exemple 4 : Exfoliation de graphite grâce à une réaction Diels-Alder utilisant de la 6,6-dihydropentacèn-13-one

Dans un tube pour centrifugeuse de 100 ml sont introduits la 6,6-dihydropentacèn-13-one de formule Il:

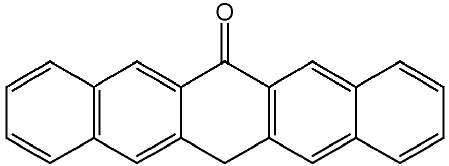

(10 mg, 0,034 mmol), du graphite en poudre (100 mg), la *N*,*N*-diisopropyléthylamine (1 mg, 0,0077 mmol) et THF (50 ml). Le mélange est mis à soniquer dans un bain à ultrasons (37 kHz, 150W) pendant 4 heures puis centrifugé pendant 30 minutes à une vitesse de 3000 tours par minute afin de séparer le graphite non exfolié. Le surnageant est alors prélevé à la pipette puis filtré sur un filtre nylon (0,22 µm de diamètre des pores), préalablement séché et pesé. L'ensemble (filtre et filtrat) est alors séché puis pesé. Une masse d'adduit Diels-Alder de graphène de 0,7 mg est ainsi obtenue, soit une concentration de 0,014 mg.ml⁻¹ d'adduit Diels-Alder de graphène en suspension dans le surnageant.

### Exemple 5 :

Le protocole expérimental de l'Exemple 2 a été répété avec différents solvants. Les résultats obtenus avec l'anthrone sont répertoriés dans le Tableau 1, y compris les résultats de l'exemple 2 avec le THF:

**Tableau 1 : Masse et concentration d'adduit Diels-Alder de graphène obtenues en fonction du solvant utilisé lors de l'exfoliation du graphite avec l'anthrone (200mg) en présence de DIPEA (20 % molaire)**

| | THF | Acétonitrile | NMP | DMF | 2-Propanol | Toluène |
|---|---|---|---|---|---|---|
| Masse d'adduit Diels-Alder de graphène (mg) | 1.0 | 0.75 | 1.5 | 2.2 | 0.5 | 1.4 |
| Concentration d'adduit Diels-Alder de graphène (mg.ml⁻¹) | 0.02 | 0.015 | 0.03 | 0.044 | 0.01 | 0.028 |

### Exemple 6 : Exfoliation de graphite grâce à une réaction Diels-Alder utilisant la thioanthracénone

Par analogie avec l'anthrone, l'utilisation de dérivés soufrés pour effectuer l'exfoliation du graphite par réaction de Diels-Alder s'avère intéressante pour la fonctionnalisation ultérieure du graphène exfolié.

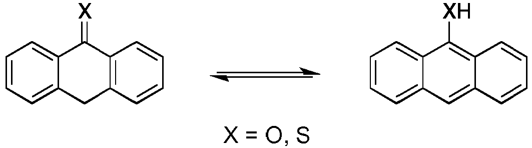

Méthode : 100 mg de graphite, 100 mg d'anthracènethiol, 20 mg de DIPEA sont mis en solution dans 50 ml de solvant (C_{graphite} = 2 mg/ml) et soniqués 4 h à 60-65 °C (180 W, 37 kHz) dans un bain à ultrasons. Le mélange est alors centrifugé 30 minutes à 3000 rpm puis laissé décanter 24 h. Le surnageant est ensuite prélevé puis filtré sur des filtres nylon (taille des pores 0,22 µm). Le solide obtenu est ainsi redispersé dans 10 ml de solvant.

| | X = S | | X = O | |
|---|---|---|---|---|
| | THF | Toluène | THF | Toluène |
| Masse (mg) | 1.34 | 1.98 | 1.0 | 1.4 |
| Concentration (mg.ml⁻¹) | 0.268 | 0.0396 | 0.02 | 0.028 |

### Exemple 7 : Exfoliation de graphite grâce à une réaction Diels-Alder utilisant la 2,6-bis(2-(2-(2-hydroxyéthoxy)éthoxy)éthoxy) anthracen-9(10H)-one

Pour améliorer le procédé d'exfoliation du graphite via la réaction de Diels-Alder avec un composé de type anthrone, la 2,6-bis(2-(2-(2-hydroxyéthoxy)éthoxy)éthoxy) anthracen-9(10*H*)-one a été utilisée. Celle-ci présente deux chaînes (PEG)₃ avec une fonction hydroxyle en bout, qui vise à améliorer l'exfoliation dans les milieux alcooliques et/ou aqueux.

Méthode : 100 mg de graphite, 50 mg de produit dérivé d'anthrone (brut), 25 mg de DIPEA sont mis en solution dans 50 ml de solvant (C_{graphite} = 2 mg/ml) et soniqués 4 h à 60-65 °C (180 W, 37 kHz) dans un bain à ultrasons. Le mélange est alors centrifugé 30 minutes à 3000 rpm puis laissé décanter 24 h. Le surnageant est ensuite prélevé puis filtré sur des filtres nylon (taille des pores 0,22 µm). Le solide obtenu est ainsi redispersé dans 10 ml de solvant.

IPA : Isopropanol (2-Propanol)

| | IPA (100 %) | IPA/H₂O (75/25) |
|---|---|---|
| Masse (mg) | 2.21 | 1.87 |
| Concentration (mg/ml) | 0.0442 | 0.0374 |

### Exemple 8 comparatif :

La qualité et les caractéristiques des feuillets de graphène obtenus par le procédé de l'invention (par exemple dans les exemples 1 à 7) peuvent être comparées à celles de procédés connus, comme :
- La sonication puissante (beaucoup plus puissante que celle préconisée pour le procédé de la présente invention). Cette méthode donne typiquement des multi-feuillets de graphène endommagés ;
- ou procéder par oxydation/réduction du graphite.

Par exemple, on pourra utiliser le protocole expérimental décrit dans la référence 11 (Tagmatarchis *et al.,* 2012).

On pourra également se référer au protocole suivant :
Une sonication à haute intensité (« tipsonication » en anglais) est réalisée avec un homogénéisateur Bandelin Sonoplus à ultrasons HD 3200 équipé d'une sonde à tête plate (VS70T), fonctionnant à 10% de la puissance maximale (250 W). Dans une expérience typique, on ajoute 50 mg de flocons de graphite pour 100 ml de solvant, [N, N-diméthylformamide examiné (DMF), tétrahydrofurane (THF), diméthylsulfoxyde (DMSO), pyridine, o-dichlorobenzène (O-DCB) ou N-méthyl-1,2-pyrrolidone (NMP)]. Le mélange est soumis à des ultrasons pendant des durées différentes (5, 15, 30 et 60 minutes). L'encre de dispersion de graphène obtenue est centrifugée pendant 15 min et le surnageant est recueilli et analysé. Sur la base de ces mesures et calculs, la concentration de graphène exfolié après 60 min de sonication à haute intensité dans l'o-DCB a été jugée 17,8 mg ml⁻¹, alors que la concentration de la dispersion de graphène exfolié dans la NMP a été mesurée à 3,8 mg ml⁻¹.

Le graphène obtenu par le procédé de l'invention (exfoliation de graphite assistée par réaction de Diels-Alder + recuit sous vide) et par les méthodes connues précitées pourront être caractérisés par spectroscopie Raman et TEM. Le graphène obtenu par le procédé de l'invention devrait contenir moins de défauts, et donc être caractérisé par les techniques spectroscopiques (absorption UV-vis, Raman) et microscopiques habituelles (AFM, SEM, TEM).

### Exemple 9 : Caractérisation par spectroscopie Raman du graphène exfolié par réaction de Diels-Alder avec les dérivés d'anthrone

### Etude DIC (Differential interférence Contrast)/Raman à λ = 568 nm (Objectif 60x).

Cette méthode consiste à dériver le contraste des différences d'indice de réfraction des composants de l'échantillon. Cela transforme le déphasage de la lumière, induite par l'indice de réfraction de l'échantillon, par des différences d'amplitude détectables.

L'avantage de cette expérience est qu'un objet va apparaître brillant sur un fond sombre, mais sans le halo de diffraction associé à un contraste de phase.

Ce procédé utilise les différences de trajet optique dans l'échantillon pour générer le contraste donc l'aspect tridimensionnel des échantillons sur l'image peut ne pas représenter la réalité.

Des échantillons ont été préparé par spin-coating sur des lames de verre à partir d'une solution de graphène dans le THF. La solution utilisée est une solution issue de la redispersion du graphène après filtration.

Des catographies ont été réalisées sur des zones d'environ 10 µm², par pas de 2 µm pour le premier spectre et de 0,6 µm pour le deuxième (Figures 8A et 8C). Sur la carte, la différence de couleur représente les différences d'intensité de la bande G, à 1578 cm⁻¹. La longueur d'onde utilisée est 568 nm.

Sur les spectres obtenus, à 1335 cm⁻¹, une bande D intense est observée, synonyme de la présence de défauts dans l'échantillon. Ceci est dû à la fonctionnalisation du matériau par l'anthrone qui crée des centres sp³ et donc des déformations structurales. Ensuite, à 2678 cm⁻¹, la forme de la bande 2D indique le nombre de couches de l'échantillon. Ici, la forme totalement lorentzienne de cette bande permet de démontrer la présence de mono-feuillets de graphène fonctionnalisé. (Figure 8)

### Exemple 10 : Exemples de réalisation d'électrodes transparentes utilisant le graphène exfolié par réaction de Diels-Alder

Une des applications majeures du graphène est la fabrication d'électrodes transparentes conductrices en utilisant des encres conductrices. Le graphène obtenu par exfoliation de graphite en utilisant le procédé ci-décrit est directement utilisable pour la fabrication de telles électrodes. Les films de graphène peuvent êtres obtenus par diverses méthodes qui ont été testées, telles que le spin-coating, le spray-coating, la filtration sous vide. Compte tenu des concentrations en graphène utilisés, la méthode de préparation de films de graphène la plus efficace est la filtration sous vide.

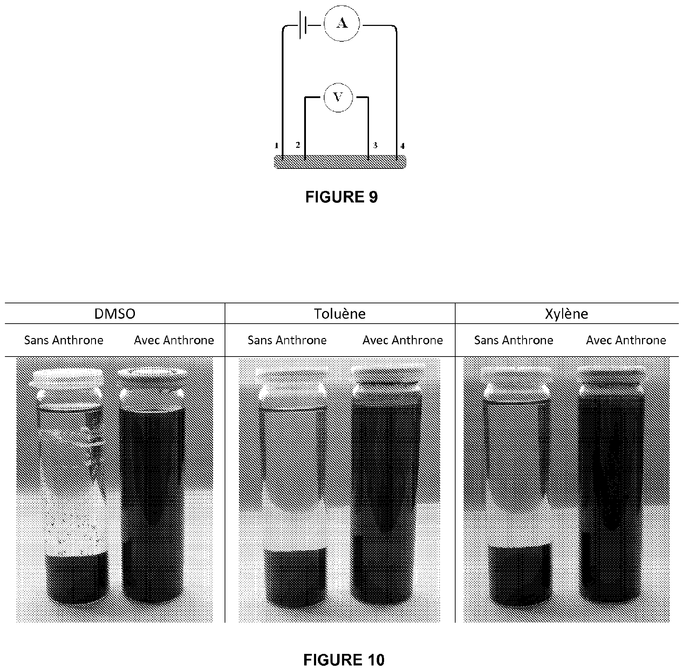

La méthode des 4 pointes (four-probe points method) a été utilisée pour mesurer la conductivité des couches de graphène: le courant est envoyé par un générateur entre les pointes 1 et 4, tandis que la tension est mesurée entre les pointes 2 et 3. Le rapport de la tension mesurée sur l'intensité qui traverse l'échantillon donne la résistance du tronçon entre les pointes 2 et 3 (Figure 9).

Pour obtenir la résistivité de cette section, on est amené à intégrer les résistances infinitésimales entre la pointe 1 et les pointes 2 et 3.

Des films de graphène ont été obtenus par filtration sous vide de solutions (50 ml) de concentrations différentes (calculées à l'aide de la loi de Beer-Lambert et d'une courbe de calibration) sur des membranes Anodisc en alumine (47 mm, 0,02 µm de taille de pores). Les résultats sont présentés dans le Tableau 2:

**Tableau 2. Conductivité de couches de graphène obtenues par filtration de 50mL de dispersion de graphène comme décrit dans la partie expérimentale.**

| Filtre | Graphite | Solvant | Concentration (mg/ml) | Résistance (Ω) | Conductance (S) |
|---|---|---|---|---|---|
| 1 | Normal | THF | 0.01 | 1,1 10⁵ | 3.8 10⁻⁵ |
| 3 | Nano | THF | 5.55 10⁻⁴ | 2,25 10⁵ | 2 10⁻⁵ |
| 4 | 100 µ | THF | 2.17 10⁻³ | 9,37 10⁴ | 4.8 10⁻⁵ |
| 5 | Normal | Toluène | 2.48 10⁻³ | 1,36 10⁵ | 3.3 10⁻⁵ |
| 7 | Normal | Toluène+THF | 2.31 10⁻³ | 1,05 10⁵ | 4.310⁻⁵ |

Les pointes utilisées sont distantes de 1,6 mm avec un rayon de 40,6 µm. Elles sont équidistantes, ainsi, la formule = 4,532 U/I (n = 3,14159) est utilisée pour calculer la résistance Rs.

### Exemple 11 : Utilisation de techniques alternatives à la sonication : le broyage

L'utilisation de la sonication pour accélérer le processus d'exfoliation par réaction de Diels-Alder peut être remplacée par toute autre technique permettant de favoriser des réactions hétérogènes. Ainsi, il est possible d'utiliser des méthodes alternatives à la sonication tels le broyage (ball-milling) ou le mixage (High-shear mixing ; Nature Materials 2014, 13, 624-630 [ref 18]).

En se référant aux récents travaux sur le mixage (high-shear mixing) permettant l'exfoliation du graphite (Nature Materials 2014, 13, 624-630), nous avons démontré que cette méthode permet de réduire considérablement l'utilisation de la sonication.
- Une première expérience a été réalisée avec une concentration initiale en graphite de 2 mg/ml soit 100 mg de graphite, 200 mg d'anthrone, 30 mg de DIPEA dans 50 ml de THF.
   Le temps de mixage est de 25 minutes, en utilisant un système rotor/stator d'un diamètre de 22 mm, à une vitesse de 4500 rpm.
   Ensuite, le mélange est soumis à la sonication 2h (180W, 37 kHz), puis purifié par centrifugation (30 minutes à 3000 rpm).
   La concentration de graphène, déterminée par la loi de Beer-Lambert à l'aide d'une courbe de calibration (ε = 26,2), est de 0,0234 mg/ml (par comparaison, C = 0,02 mg/ml pour 4 h de sonication sans mixage)
- Dans une autre expérience à plus grande échelle, une concentration initiale en graphite de 30 mg/ml soit 1,0 g de graphite, 1,5 g d'anthrone, 180 mg de DIPEA dans 50 ml de THF a été utilisée.
   Dans les mêmes conditions de réaction que précédemment, la concentration de graphène obtenue est de 0,0765 mg/ml.

### Exemple 12 : Stabilisation de suspensions de noir de charbon

Le procédé consiste à soniquer dans un bain à ultrasons (4 h, 180 W, 60 °C) du noir de charbon graphitique (100 mg) en présence de d'anthrone (200 mg) et de *N,N-*diisopropyléthylamine (30 mg, 20 mol%) dans un solvant organique (50 ml).

On obtient des suspensions stables dans différents solvants organiques (Figure 10).

À la lecture de la présente demande et des exemples illustratifs ci-dessus, l'homme du métier constatera que le présent procédé est général et qu'il est applicable avec tous les graphites connus de l'homme du métier.

### Liste des références

[1] Chakraborty et al., « Functionalization of potassium graphite », Angew. Chem. Int. Ed., 46, 4486-4488 (2007).
[2] Niyogi et al., « Solution Properties of Graphite and Graphene », J. Am. Chem. Soc., 128, 7720-7721 (2006).
[3] McAllister et al., « Single Sheet Functionalized Graphene by Oxidation and Thermal Expansion of Graphite », Chem. Mater., 2007; 19 (18), 4396-4404
[4] Qing Hua Wang et al., « Understanding and controlling the substrate effect on graphene electron-transfer chemistry via reactivity imprint lithography », Nature Chemistry, 2012, 4, 724-732.
[5] Rozhkov et al., « Electronic properties of mesoscopic graphene structures: Charge confinement and control of spin and charge transport », Physics Reports, 503 (2011) 77-114.
[6] Cui et al., « Graphene-Enriched P3HT and Porphyrin-Modified ZnO Nanowire Arrays for Hybrid Solar Cell Applications », J. Phys. Chem. C, 2012, 116, 9433-9438.
[7] Chhowalla et al., « Large-area ultrathin films of reduced grapheme oxide as a pransparent and flexible electronic material », Nature Natotechnology, Vol. 3, 2008, 270-274.
[8] Kong et al., « Graphene as transparent conducting électrodes in organic photovoltaics: Studies in graphene morphology, hole transporting layers, and counter électrodes », Nano Letters, 2012, 12, 133-140.
[9] Müllen et al., « Transparent, conductive grapheme électrodes for dye-sensitized solar cells », Nano Letters, 2008, Vol. 8(1), 323-327.
[10] Kim et al., « Transparent conductive graphene electrode in GaN-based ultraviolet light emitting diodes », Optics Express, Vol. 18(22), 2010, 23030-23034.
[11] Tagmatarchis et al., « Graphene exfoliation in organic solvents and switching solubility in aqueous media with the aid of amphiphilic block copolymers », J. Mater. Chem., 2012, 22, 21507-21512.
[12] Goichi et al., « Improved Synthesis of 1,8-Diiodoanthracene and Its Application to the Synthesis of Multiple Phenylethynyl-Substituted Anthracenes », Synthesis, 2005(13): 2116-2118.
[13] Li et al., « Synthesis of 1,2,3,4,8,9,10,11-Octasubstituted Pentacenequinone Dérivatives and their Conversion into Substituted Pentacenes », Chemistry - An Asian Journal, 2010, 5, 1620-1626.
[14] Haddon et al., Accounts of Chemical research, vol. 45(4), 2012, 673-682
[15] Haddon et al. JACS, 133, 2011, 3324-3327.
[16] KR2012-0104767.
[17] Zhao, W., Fang, M., Wu, F., Wu, H., Wang, L. & Chen, G. Préparation of graphene by exfoliation of graphite using wet ball milling. J. Mater. Chem. 20, 5817-5817 (2010).
[18] Paton et al., Nature materials, 2014, 13, 624-630.
[19] Santanu Sarkar et al,. « Diels-Alder chemistry of graphite and graphene: graphene as diene and dienophile », Journal of the american chemical society, vol. 133, no, 10, 16 mars 2011, pages 3324-3327
[20] Olivier Riant et al., « Asymmetric Diels-Alder reaction catalyzed by chiral bases », Tetrahedron letters, vol.30 no. 52, 1 janvier 1989, pages 7403-7406

## Revendications

1. Procédé d'exfoliation de graphite **caractérisé en ce qu'**il comprend une réaction Diels-Alder entre du graphite et un composé répondant à l'une des structures suivantes : 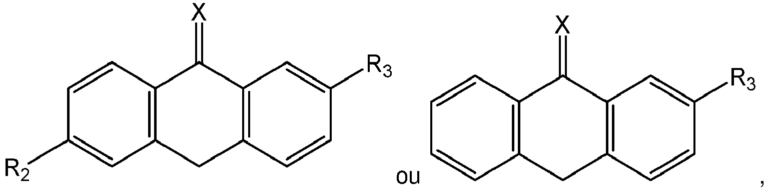 dans laquelle
X représente O ou S ;
R₂, R₃ représentent indépendamment un atome d'hydrogène, -NR^{A}R^{B}, ou -OR ; où chaque occurrence de R, R^{A} et R^{B} représente indépendamment un atome d'hydrogène, ou un groupe méthyle, éthyle, n-propyle, i-propyle, n-butyle, t-butyle, sec-butyle, n-pentyle, ou n-hexyle; et R, pour chaque occurrence, peut également représenter un radical polyéthylène glycol de formule : 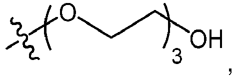
pour conduire à un composé de type pentacènone ayant l'une des structures suivantes : 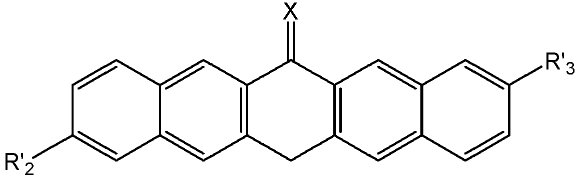 ou 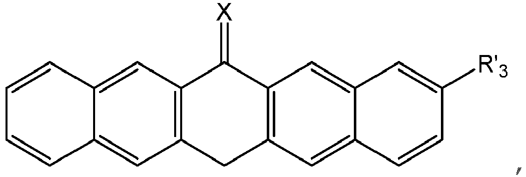 dans laquelle
X représente O ou S ;
R'₂, R'₃ représentent indépendamment un atome d'hydrogène, -NR^{A}R^{B}, ou -OR ; où chaque occurrence de R, R^{A} et R^{B} représente indépendamment un atome d'hydrogène, ou un groupe méthyle, éthyle, n-propyle, i-propyle, n-butyle, t-butyle, sec-butyle, n-pentyle, ou n-hexyle; et R, pour chaque occurrence, peut également représenter un radical polyéthylène glycol de formule : 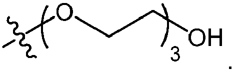
dans un solvant organique, en présence d'une base, et sous sonication, broyage et/ou mixage, à une température comprise entre 15°C et 65°C ; pour obtenir l'adduit Diels-Alder de graphène correspondant.

2. Procédé selon la revendication 1, dans lequel le composé de formule 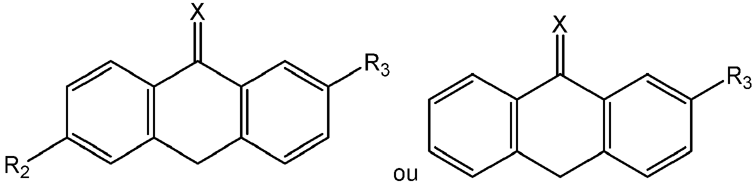 répond à l'une des structures suivantes : 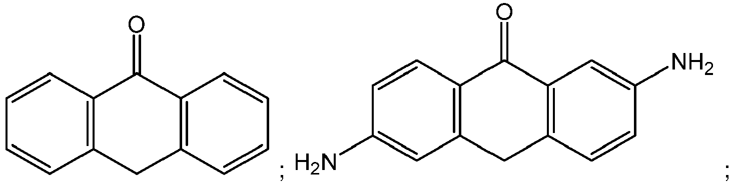 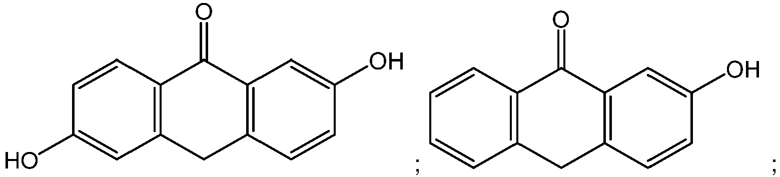 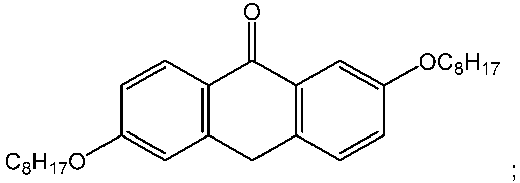 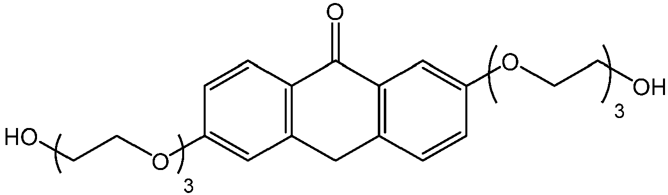 ou

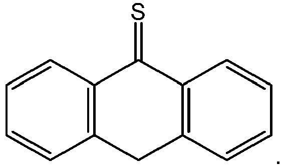

3. Procédé selon la revendication 1 ou 2, dans lequel le solvant organique est choisi parmi un hydrocarbure aliphatique ou alicyclique saturé ou insaturé, un hydrocarbure aromatique, un alcool de préférence comprenant au moins 3 atomes de carbone, un glycol, un hydrocarbure halogéné, une cétone, un ester, un éther, un éther de glycol, ou un mélange de deux ou plus de ceux-ci.

4. Procédé selon l'une quelconque des revendications 1 à 3, dans lequel le solvant organique est choisi parmi le tétrahydrofurane (THF), l'acétonitrile, la N-méthyl-2-pyrrolidone (NMP), le diméthylformamide (DMF), le 2-propanol, le toluène, le benzène, le chlorobenzène, le 1,2-dichlorobenzène.

5. Procédé selon l'une quelconque des revendications 1 à 4, dans lequel la base est une di- ou trialkylamine, telle que la diéthylamine, diméthylamine, aza-éthercourone, diisopropylamine, diisopropyléthylamine, triéthylamine, triméthylamine, tripropylamine, tributylamine, N-méthylcyclohexylamine, N-éthylcyclohexylamine, N-méthylcyclopentylamine, ou N-éthylcyclopentylamine.

6. Procédé selon l'une quelconque des revendications 1 à 5, dans lequel la réaction Diels-Alder est réalisée à une température de 20-65°C.

7. Procédé selon l'une quelconque des revendications 1 à 6, comprenant en outre une étape de centrifugation.

8. Procédé selon la revendication 7, comprenant en outre une étape de filtration du surnageant obtenu à l'issue de la centrifugation pour isoler l'adduit Diels-Alder de feuillets de graphène obtenus par le procédé.

9. Procédé selon l'une quelconque des revendications 1 à 8, dans lequel le graphite est du HOPG (highly oriented pyrolytic graphite), ou du graphite amorphe ou cristallin, ou bien du graphite présent dans du noir de charbon (« carbon black » en anglais).

10. Procédé selon l'une quelconque des revendications 1 à 9, comprenant en outre une étape de recuit sous vide de l'adduit Diels-Alder de feuillets de graphène pour obtenir des mono-feuillets ou multi-feuillets de 2 à 5 feuillets de graphène, ou un mélange de ceux-ci.

11. Adduit Diels-Alder de feuillets de graphène susceptible d'être obtenu selon l'une quelconque des revendications 1 à 9.

## Patentansprüche

1. Verfahren zum Exfolieren von Graphit, **dadurch gekennzeichnet, daß** es eine Diels-Alder-Reaktion zwischen Graphit und einer Verbindung mit einer der folgenden Strukturen umfaßt: 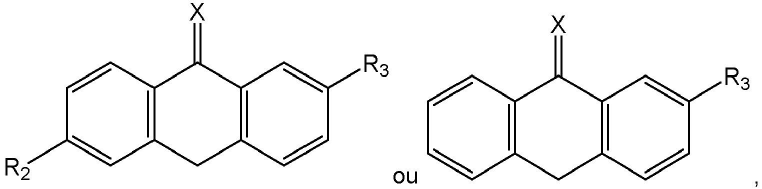 wobei
X für O oder S steht;
R₂, R₃ unabhängig voneinander Wasserstoff, -NR^{A}R^{B} oder -OR sind; wobei jedes Auftreten von R, R^{A} und R^{B} unabhängig voneinander Wasserstoff, Methyl, Ethyl, n-Propyl, i-Propyl, n-Butyl, t-Butyl, sec-Butyl, n-Pentyl oder n-Hexyl ist; und R bei jedem Auftreten auch ein Polyethylenglykolrest der Formel sein kann : 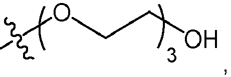
um eine Pentacenonverbindung mit einer der folgenden Strukturen zu erhalten : 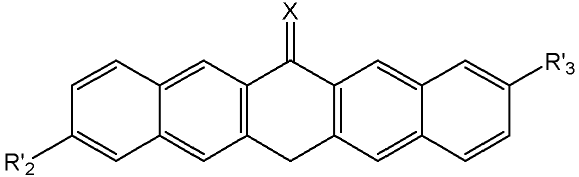 oder 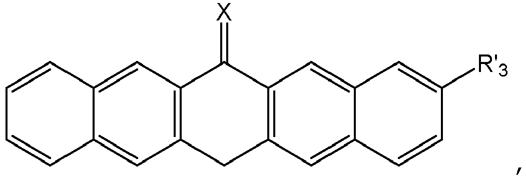 worin
X für O oder S steht;
R'₂, R'₃ unabhängig voneinander Wasserstoff, -NR^{A}R^{B} oder -OR sind; wobei jedes Auftreten von R, R^{A} und R^{B} unabhängig voneinander Wasserstoff, Methyl, Ethyl, n-Propyl, i-Propyl, n-Butyl, t-Butyl, sec-Butyl, n-Pentyl oder n-Hexyl ist; und R bei jedem Auftreten auch ein Polyethylenglykol-Rest der Formel sein kann: 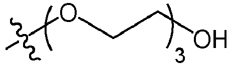
in einem organischen Lösungsmittel, in Gegenwart einer Base und unter Beschallung, Zerkleinern und/oder Mischen bei einer Temperatur zwischen 15°C und 65°C, um das entsprechende Diels-Alder-Addukt von Graphen zu erhalten.

2. Verfahren nach Anspruch 1, wobei die Verbindung der Formel 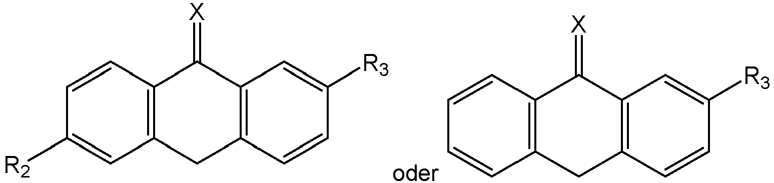 auf eine der folgenden Strukturen is: 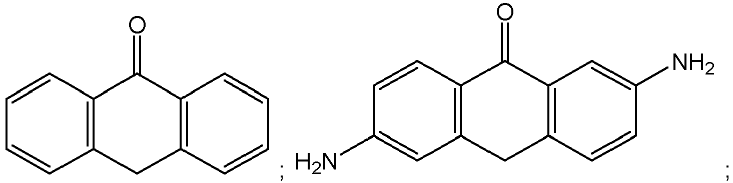 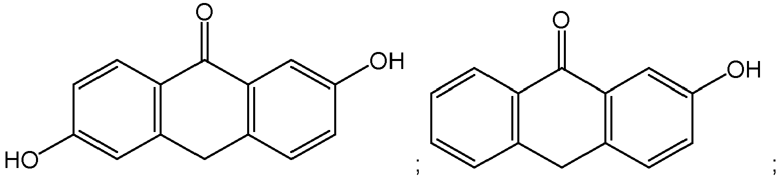 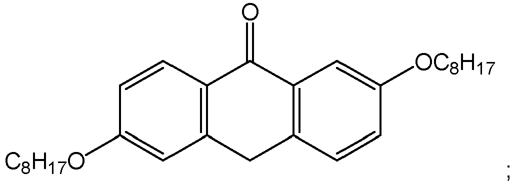 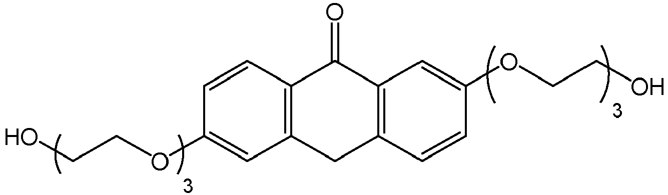 oder

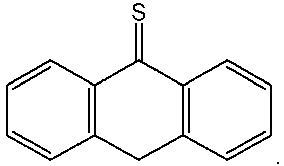

3. Verfahren nach Anspruch 1 oder 2, wobei das organische Lösungsmittel ausgewählt ist aus einem gesättigten oder ungesättigten aliphatischen oder alicyclischen Kohlenwasserstoff, einem aromatischen Kohlenwasserstoff, einem Alkohol, der vorzugsweise mindestens 3 Kohlenstoffatome umfasst, einem Glykol, einem halogenierten Kohlenwasserstoff, einem Keton, einem Ester, einem Ether, einem Glykolether oder einem Gemisch aus zwei oder mehreren davon.

4. Verfahren nach einem der Ansprüche 1 bis 3, wobei das organische Lösungsmittel ausgewählt ist aus Tetrahydrofuran (THF), Acetonitril, N-Methyl-2-pyrrolidon (NMP), Dimethylformamid (DMF), 2-Propanol, Toluol, Benzol, Chlorbenzol, 1,2-Dichlorbenzol.

5. Verfahren nach einem der Ansprüche 1 bis 4, wobei die Base ein Di- oder Trialkylamin ist, wie Diethylamin, Dimethylamin, Aza-Ethercouron, Diisopropylamin, Diisopropylethylamin, Triethylamin, Trimethylamin, Tripropylamin, Tributylamin, N-Methylcyclohexylamin, N-Ethylcyclohexylamin, N-Methylcyclopentylamin oder N-Ethylcyclopentylamin.

6. Verfahren nach einem der Ansprüche 1-5, wobei die Diels-Alder-Reaktion bei einer Temperatur von 20-65°C durchgeführt wird.

7. Das Verfahren nach einem der Ansprüche 1 bis 6 umfasst ferner einen Zentrifugationsschritt.

8. Verfahren nach Anspruch 7, das ferner einen Schritt des Filtrierens des bei der Zentrifugation erhaltenen Überstandes umfasst, um das Diels-Alder-Addukt aus den durch das Verfahren erhaltenen Graphenblättern zu isolieren.

9. Verfahren nach einem der Ansprüche 1 bis 8, wobei der Graphit HOPG (hochorientierter pyrolytischer Graphit), amorpher oder kristalliner Graphit oder in Ruß vorhandener Graphit ist.

10. Verfahren nach einem der Ansprüche 1 bis 9, das ferner einen Schritt des Vakuumtemperns des Diels-Alder-Addukts von Graphenblättern umfasst, um einzelne oder mehrere Blätter von 2 bis 5 Graphenblättern oder eine Mischung davon zu erhalten.

11. Diels-Alder-Addukt von Graphenblättern, erhältlich nach einem der Ansprüche 1 bis 9.

## Claims

1. A process for exfoliating graphite **characterized in that** it comprises a Diels-Alder reaction between graphite and a compound having one of the following structures: 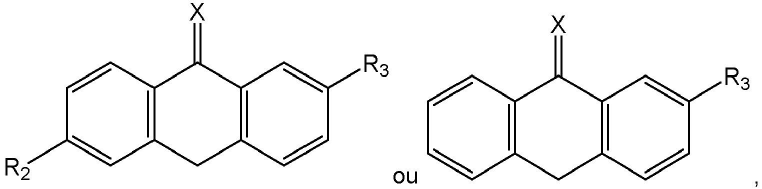 wherein
X is O or S;
R₂, R₃ are independently hydrogen, -NR^{A}R^{B}, or -OR; wherein each occurrence of R, R^{A}, and R^{B} is independently hydrogen, methyl, ethyl, n-propyl, i-propyl, n-butyl, t-butyl, sec-butyl, n-pentyl, or n-hexyl; and R, for each occurrence, may also be is a polyethylene glycol radical of the formula : 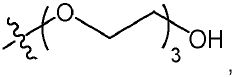
to yield a pentacenone compound having one of the following structures: 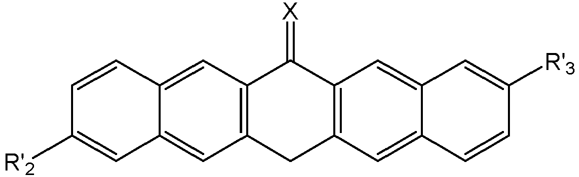 or 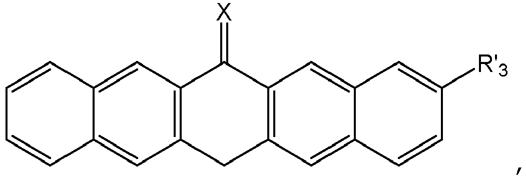 wherein
X represents O or S ;
R'₂, R'₃ are independently hydrogen, -NR^{A}R^{B}, or -OR; wherein each occurrence of R, R^{A}, and R^{B} is independently hydrogen, methyl, ethyl, n-propyl, i-propyl, n-butyl, t-butyl, sec-butyl, n-pentyl, or n-hexyl; and R, for each occurrence, may also be a polyethylene glycol radical of the formula : 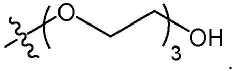
in an organic solvent, in the presence of a base, and under sonication, grinding and/or mixing, at a temperature between 15°C and 65°C; to obtain the corresponding Diels-Alder adduct of graphene.

2. The method of claim 1, wherein the compound of the formula 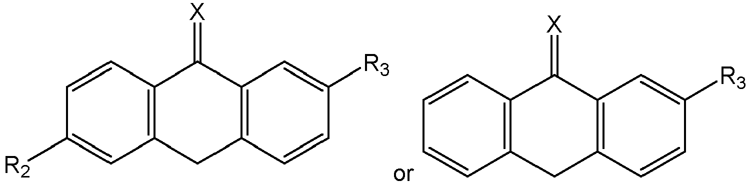 responds to one of the following structures: 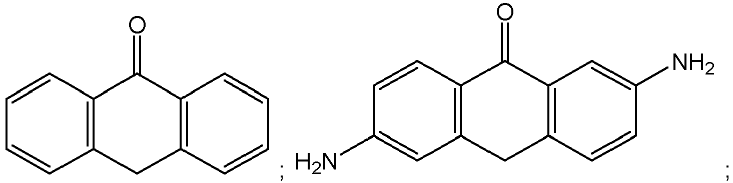 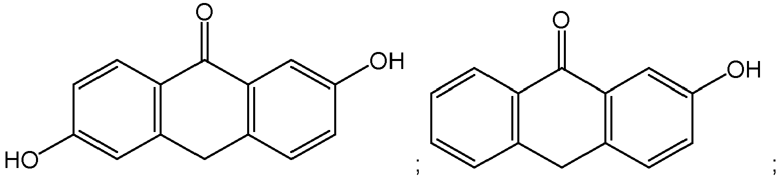 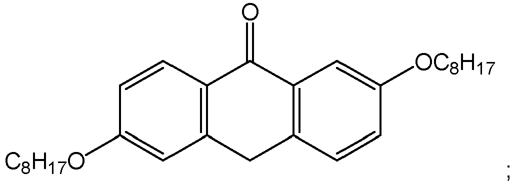 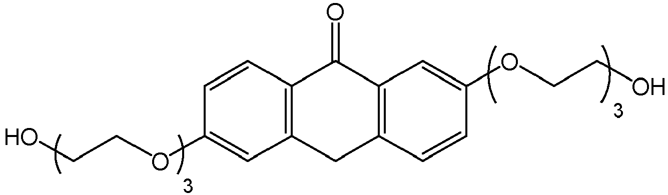 or

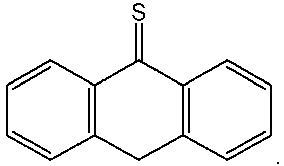

3. The method of claim 1 or 2, wherein the organic solvent is selected from a saturated or unsaturated aliphatic or alicyclic hydrocarbon, an aromatic hydrocarbon, an alcohol preferably comprising at least 3 carbon atoms, a glycol, a halogenated hydrocarbon, a ketone, an ester, an ether, a glycol ether, or a mixture of two or more thereof.

4. The method according to any one of claims 1 to 3, wherein the organic solvent is selected from tetrahydrofuran (THF), acetonitrile, N-methyl-2-pyrrolidone (NMP), dimethylformamide (DMF), 2-propanol, toluene, benzene, chlorobenzene, 1,2-dichlorobenzene.

5. The method of any one of claims 1 to 4, wherein the base is a di- or trialkylamine, such as diethylamine, dimethylamine, aza-ethercourone, diisopropylamine, diisopropylethylamine, triethylamine, trimethylamine, tripropylamine, tributylamine, N-methylcyclohexylamine, N-ethylcyclohexylamine, N-methylcyclopentylamine, or N-ethylcyclopentylamine.

6. The method of any one of claims 1-5, wherein the Diels-Alder reaction is carried out at a temperature of 20-65°C.

7. The method of any one of claims 1 to 6, further comprising a centrifugation step.

8. The method of claim 7, further comprising a step of filtering the supernatant obtained from the centrifugation to isolate the Diels-Alder adduct from graphene sheets obtained by the method.

9. The method of any one of claims 1 to 8, wherein the graphite is HOPG (highly oriented pyrolytic graphite), or amorphous or crystalline graphite, or graphite present in carbon black.

10. The method of any one of claims 1 to 9, further comprising a step of vacuum annealing the Diels-Alder adduct of graphene sheets to obtain single or multi-sheets of 2 to 5 graphene sheets, or a mixture thereof.

11. The Diels-Alder adduct of graphene sheets obtainable according to any of claims 1 to 9.
